# EUROPEAN PATENT SPECIFICATION

(11) **EP 4 057 328 B1**
(45) Date of publication and mention of the grant of the patent: **04.03.2026**
(21) Application number: 22156147.5
(22) Date of filing: 10.02.2022
(51) Int. Cl.: H01L 21/768, H01L 23/522, H01L 23/528

(54) **STACKED VIAS WITH BOTTOM PORTIONS FORMED USING SUBTRACTIVE PATTERNING**
GESTAPELTE DURCHGÄNGE MIT DURCH SUBTRAKTIVE STRUKTURIERUNG GEBILDETEN BODENABSCHNITTEN
TROUS D'INTERCONNEXION EMPILÉS AYANT DES PARTIES INFÉRIEURES FORMÉES AU MOYEN DE MOTIFS SOUSTRACTIFS

(30) Priority: 10.03.2021 US 202117197635
(43) Date of publication of application: 14.09.2022
(73) Proprietor: Intel Corporation, Santa Clara, CA 95054 (US)
(72) Inventor: WEI, Andy Chih-Hung, Yamhill, 97148 (US); BOUCHE, Guillaume, Portland, 97211 (US)
(74) Representative: 2SPL Patentanwälte PartG mbB

(56) References cited:
- US-A1- 2012 086 128
- US-A1- 2021 050 259
- US-B1- 6 413 872
- US-B1- 9 922 929

## Description

### Technical Field

This disclosure relates generally to the field of semiconductor devices, and more specifically, to metallization stacks with integrated vias.

### Background

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize the performance of each device and each interconnect becomes increasingly significant.

US 2012/0086128 A1 discloses a metal layer deposited on a planar surface on which top surfaces of underlying metal vias are exposed. The metal layer is patterned to form at least one metal block, which has a horizontal cross-sectional area of a metal line to be formed and at least one overlying metal via to be formed.

US 6,413,872 B1 discloses a technique for laying out Vias between metal layers in an integrated circuit structure utilizing conventional Metal n and Metal N+1 databases. A first database is created that defines a lower conductive layer. A second database (Metal N+1) is created that defines an upper conductive layer.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 provides a flow diagram of an example method of using subtractive patterning for forming bottom portions of stacked vias integrated in metallization stacks of integrated circuit (IC) structures, in accordance with some embodiments.
FIGS. 2A-2P illustrate top-down and cross-sectional side views at various stages in the manufacture of an example IC structure according to the method of FIG. 1, in accordance with some embodiments.
FIG. 3 illustrates various views of a stacked via of an example IC structure manufactured according to the method of FIG. 1, in accordance with some embodiments.
FIGS. 4A-4C illustrate top-down and cross-sectional side views of alternative embodiments of the IC structure manufactured according to the method of FIG. 1, in accordance with some embodiments.
FIGS. 5A and 5B are top views of, respectively, a wafer and dies that may include one or more stacked vias with bottom portions formed using subtractive patterning in accordance with any of the embodiments disclosed herein.
FIG. 6 is a cross-sectional side view of an IC package that may include one or more stacked vias with bottom portions formed using subtractive patterning in accordance with any of the embodiments disclosed herein.
FIG. 7 is a cross-sectional side view of an IC device assembly that may include one or more stacked vias with bottom portions formed using subtractive patterning in accordance with any of the embodiments disclosed herein.
FIG. 8 is a block diagram of an example computing device that may include one or more stacked vias with bottom portions formed using subtractive patterning in accordance with any of the embodiments disclosed herein.

### Detailed Description

### Overview

The systems, methods and devices of this disclosure each have several innovative aspects, no single one of which is solely responsible for all of the desirable attributes disclosed herein. Details of one or more implementations of the subject matter described in this specification are set forth in the description below and the accompanying drawings.

For purposes of illustrating IC structures with one or more stacked vias with bottom portions formed using subtractive patterning for improved via integration in the back-end-of-line (BEOL) as described herein, it might be useful to first understand phenomena that may come into play in such arrangements. The following foundational information may be viewed as a basis from which the present disclosure may be properly explained. Such information is offered for purposes of explanation only and, accordingly, should not be construed in any way to limit the broad scope of the present disclosure and its potential applications.

ICs commonly include electrically conductive microelectronic structures, known in the art as interconnects, to provide electrical connectivity between various components. In this context, the term "metallization stack" may be used to describe a stacked series of layers of electrically conductive wires (sometimes referred to as "metal lines") which are electrically insulated from one another except for when/where they may need to be electrically connected. In a typical metallization stack, electrical connections between metal lines of different layers of a metallization stack (such layers sometimes referred to as "metal layers" or "metallization layers") are realized by means of vias filled with one or more electrically conductive materials, extending in a direction substantially perpendicular to the planes of the metal lines (i.e., extending in a vertical direction if the plane of the metal lines is considered to be a horizontal plane). Such vias are, therefore, integrated within the metallization stacks.

In the past, the sizes and the spacing of interconnects such as metal lines and vias have progressively decreased, and it is expected that in the future the sizes and the spacing of the interconnects will continue to progressively decrease, for at least some types of ICs (e.g., advanced microprocessors, chipset components, graphics chips, etc.). One measure of a size of a metal line is the critical dimension of the line width. One measure of the spacing of the metal lines is the line pitch, representing the center-to-center distance between the closest adjacent metal lines of a given layer of a metallization stack.

Smaller and smaller sizes and spacing of interconnects demands that performance of every interconnect is optimized. Particularly challenging are so-called "transition vias", which are vias that provide electrical connectivity between metal layers of different pitches. Typically, lower metal layers (i.e., layers of metallization stacks which are closer to the front-end-of line (FEOL) devices, such as transistors) are denser (i.e., have smaller pitches) than upper metal layers, which may be attributed to the lower metal layers having to provide electrical connectivity to various portions of a vast number of FEOL devices. For example, lower metal layers may have pitches on the order of 18-22 nanometers, while upper metal layers may have pitches on the order of 35-40 nanometers. Transition vias need to be designed to allow for the pitch transition, as well as the change in patterning strategy used to form metal lines of lower and upper metal layers (e.g., lower, denser metal lines may command innovative and more expensive fabrication processes while metal liners of upper layers may use classic Damascene fabrication).

Disclosed herein are methods for fabricating IC structures that include stacked vias providing electrical connectivity between metal lines of different layers of a metallization stack, as well as resulting IC structures. An example IC structure includes a first and a second metallization layers provided over a support structure (e.g., a substrate, a wafer, or a chip), where the first metallization layer includes a bottom metal line, the second metallization layer includes a top metal line, and the first metallization layer is between the support structure and the second metallization layer. The IC structure further includes a via that has a bottom via portion and a top via portion, where the top via portion is stacked over the bottom via portion (hence, the via may be referred to as a "stacked via"). The bottom via portion is coupled and self-aligned to the bottom electrically conductive line, while the top via portion is coupled and self-aligned to the top electrically conductive line. The bottom via portion is formed using subtractive patterning, while the top via portion may be formed using a different fabrication technique, such as Damascene (e.g., dual Damascene) fabrication. Such a stacked via with a bottom portion formed using subtractive patterning may be particularly beneficial when used as a transition via. However, in general, stacked vias described herein are not limited to providing electrical connectivity between metal lines of metallization layers of different pitches (i.e., in various embodiments, the pitch of the first metallization layer that includes the bottom metal line as described herein may be the same or different from the pitch of the second metallization layer that includes the top metal line as described herein). Therefore, descriptions provided herein with reference to "transition vias" are equally applicable to stacked vias providing electrical connectivity between metal lines of different metallization layers of the same pitches.

As used herein, the term "bottom metal line" refers to any electrically conductive structure/line that is provided in a layer of a metallization stack that is closer to the support structure than another layer of the metallization stack, while the term "top metal line" refers to any electrically conductive structure/line that is provided in the layer of the metallization stack that is above the layer of the bottom metal lines. In other words, the bottom metal lines are provided in a layer of the metallization stack that is between the support structure and the layer in which the top metal lines are provided. In various embodiments, such bottom and top metal lines may include electrically conductive structures other than lines/trenches (e.g., at least a portion of the bottom metal line may be a gate contact), and/or may be formed, or include, electrically conductive materials other than metals.

IC structures as described herein, in particular IC structures (e.g., metallization stacks) with one or more stacked vias with bottom portions formed using subtractive patterning as described herein, may be used for providing electrical connectivity to one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

For purposes of explanation, specific numbers, materials and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well-known features are omitted or simplified in order not to obscure the illustrative implementations.

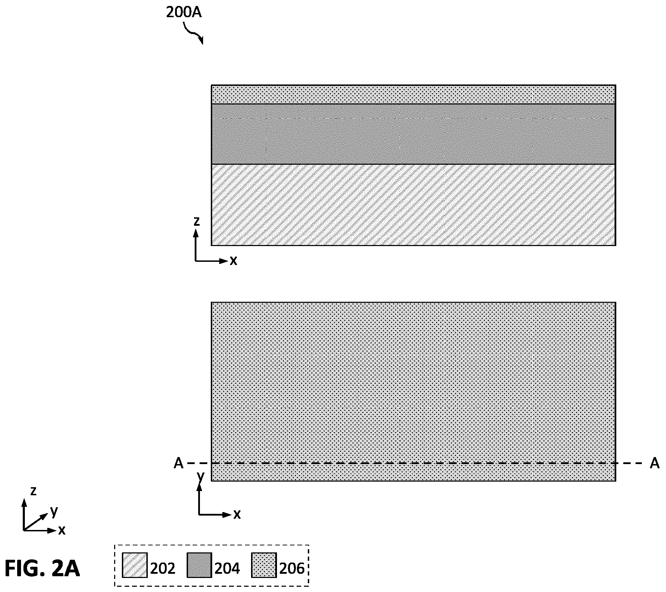

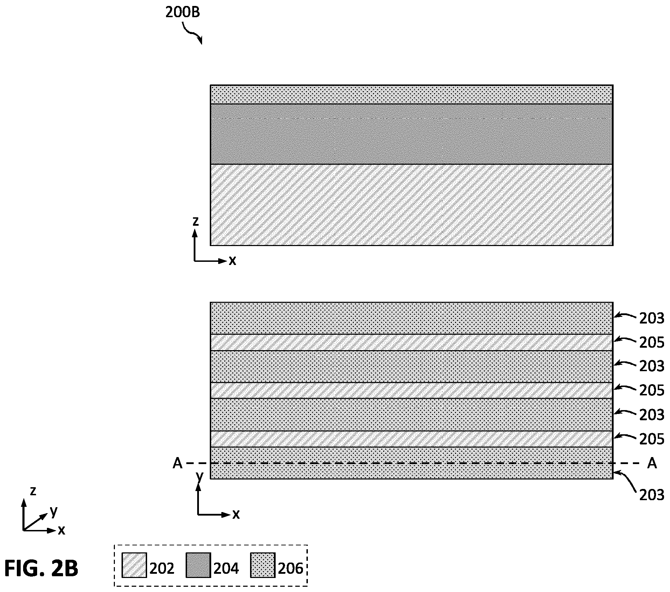

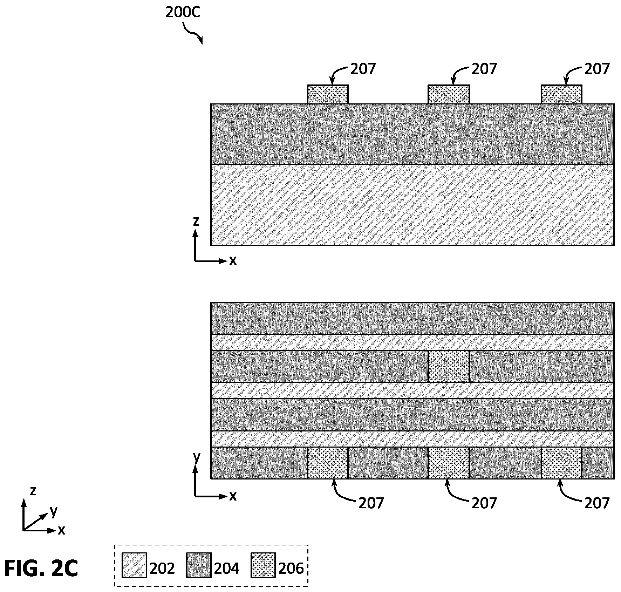

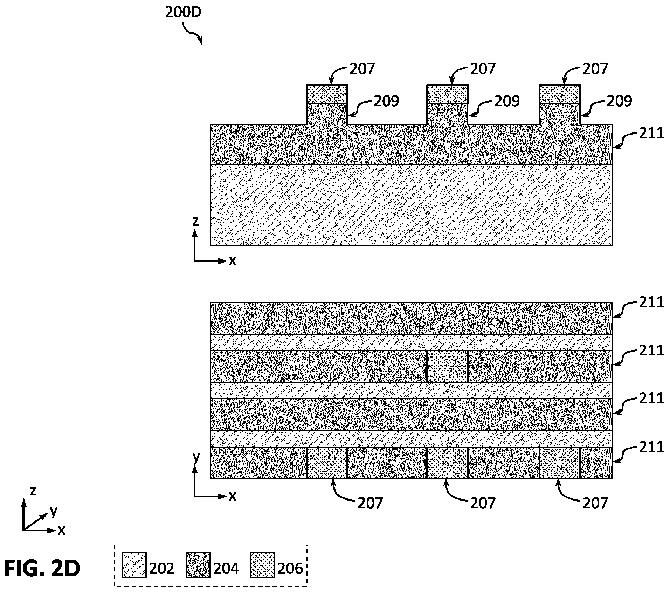

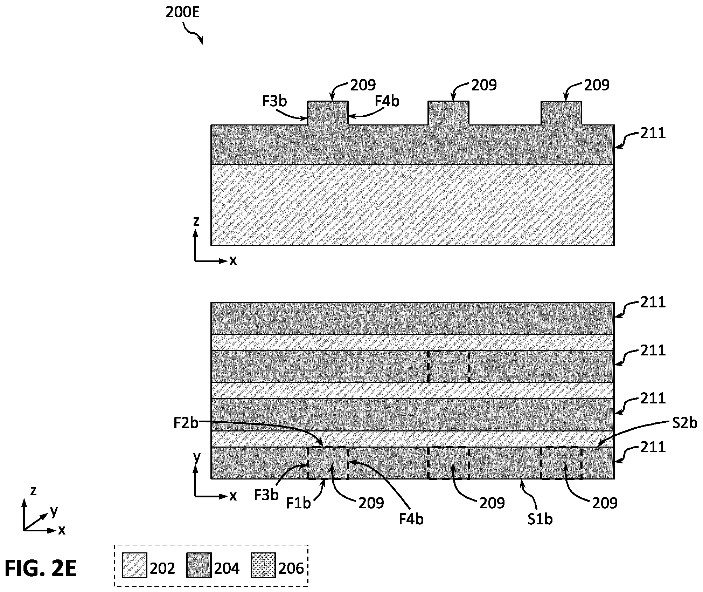

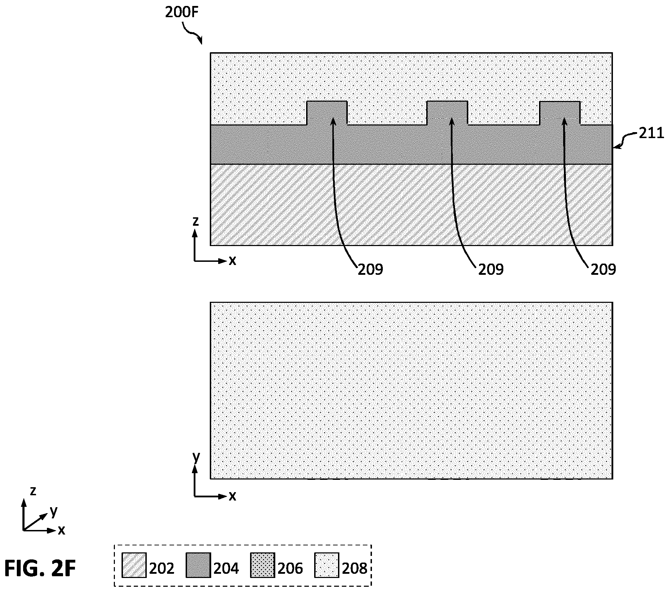

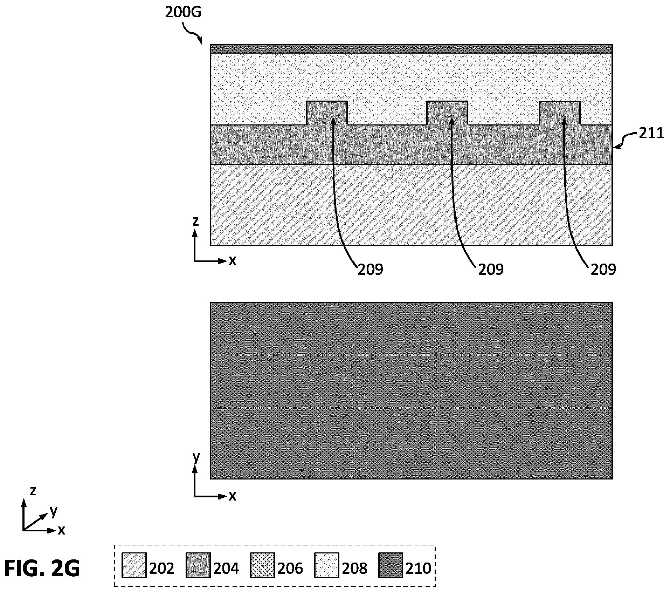

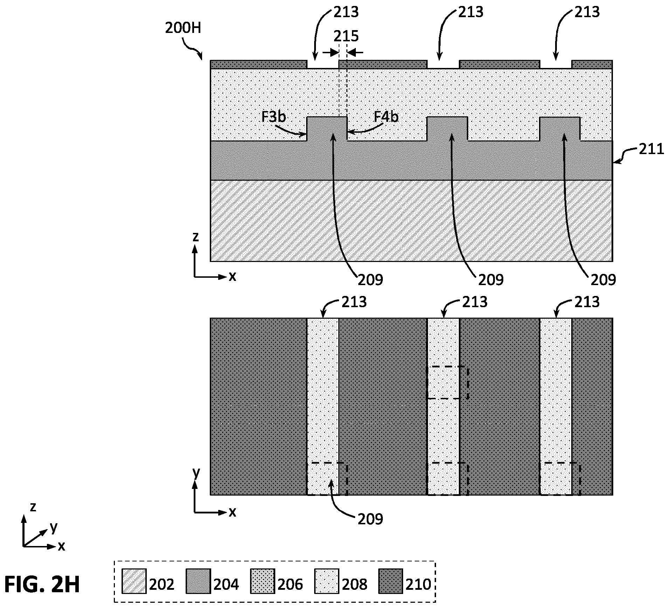

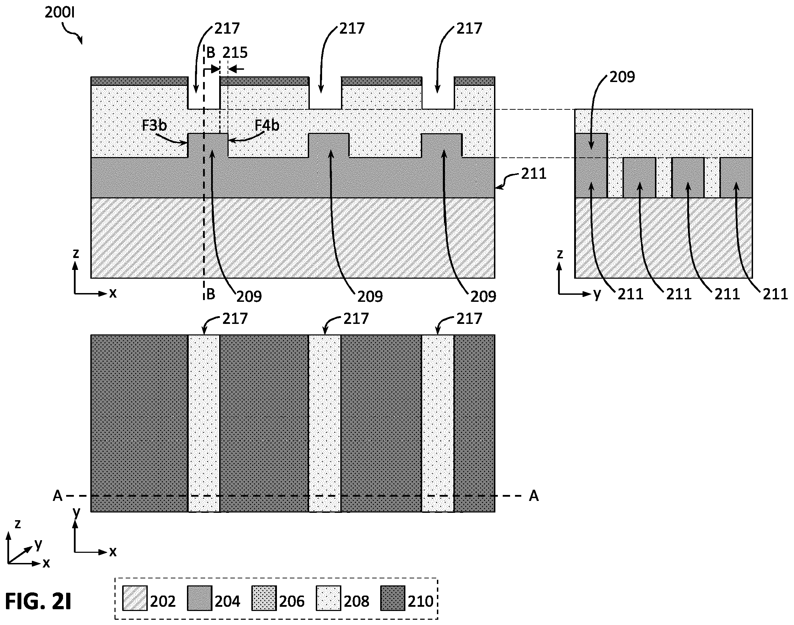

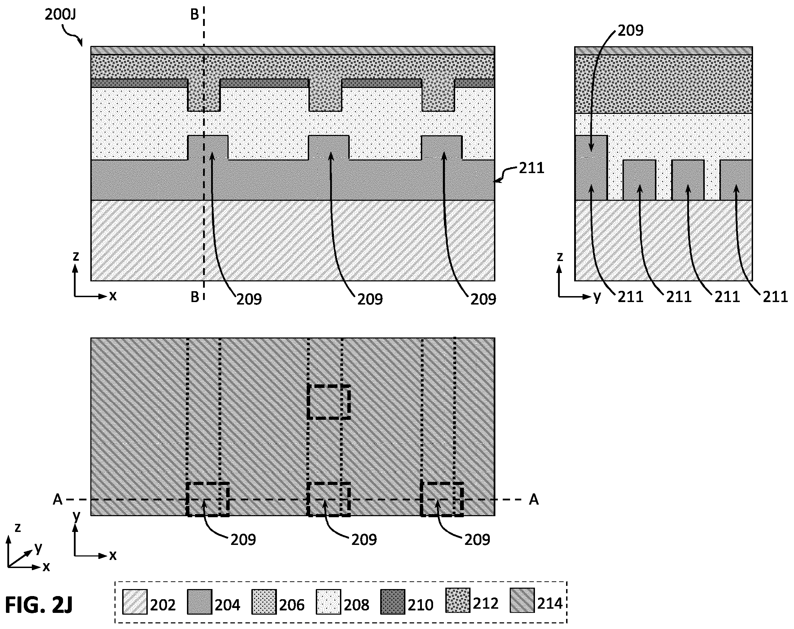

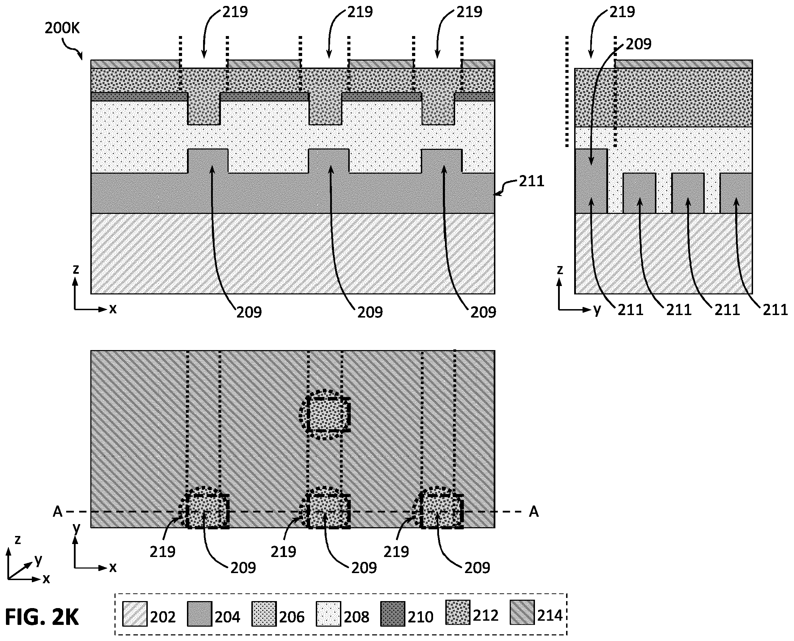

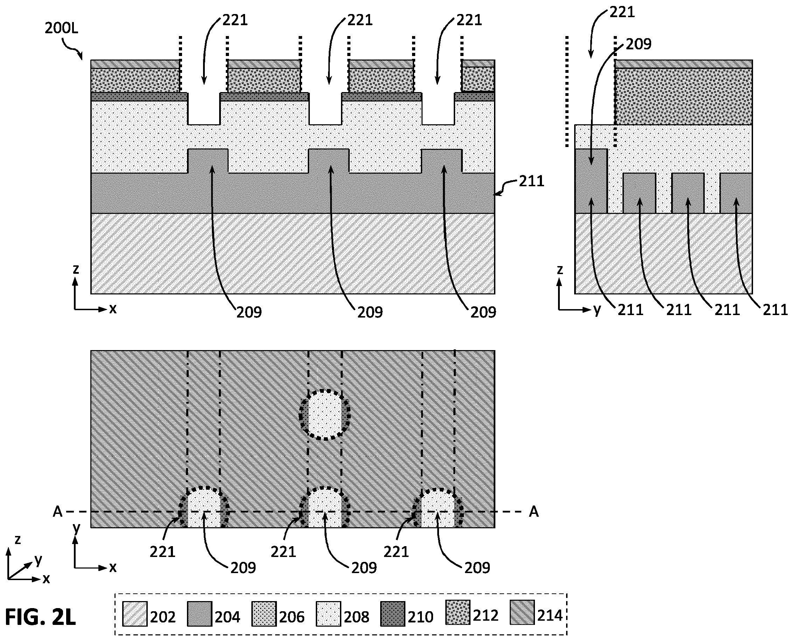

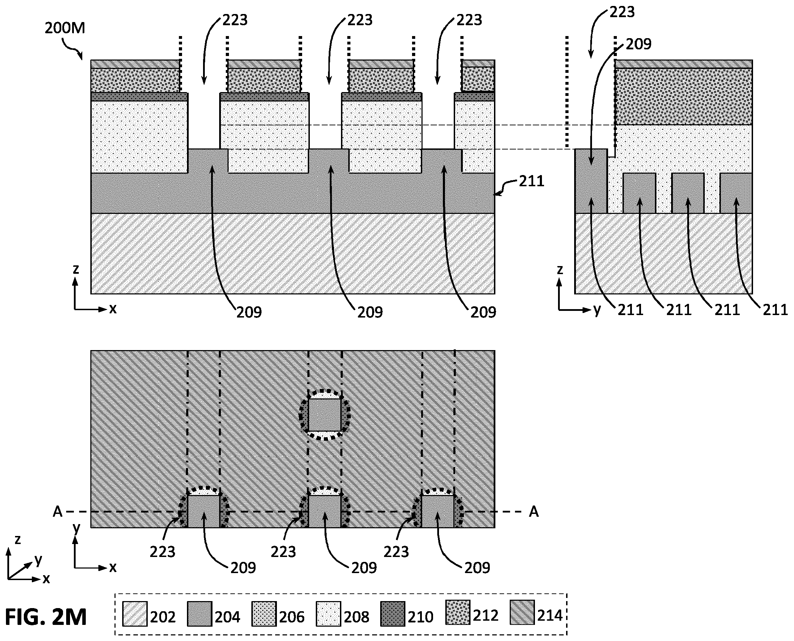

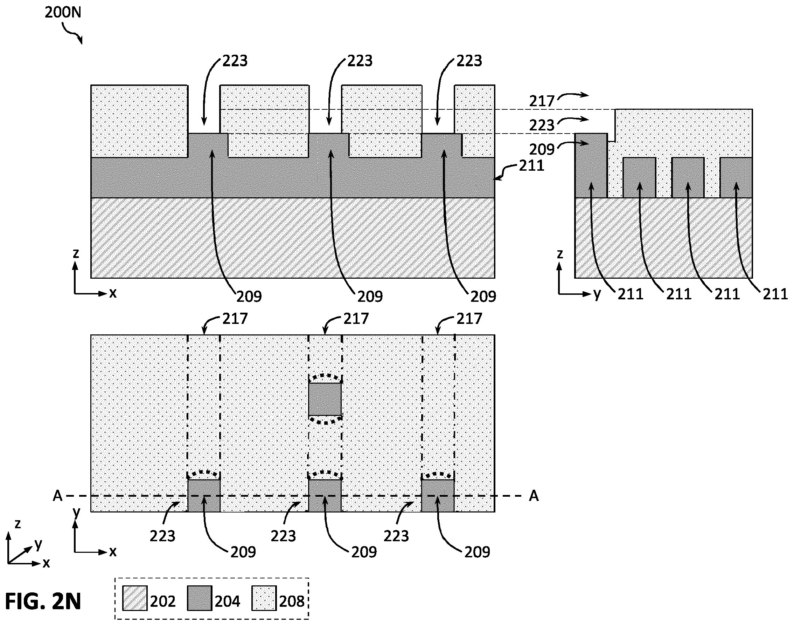

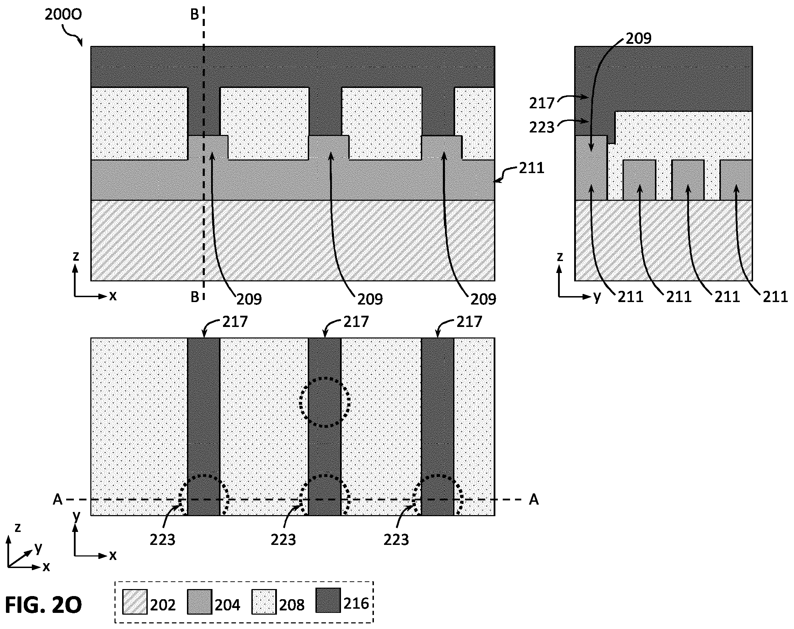

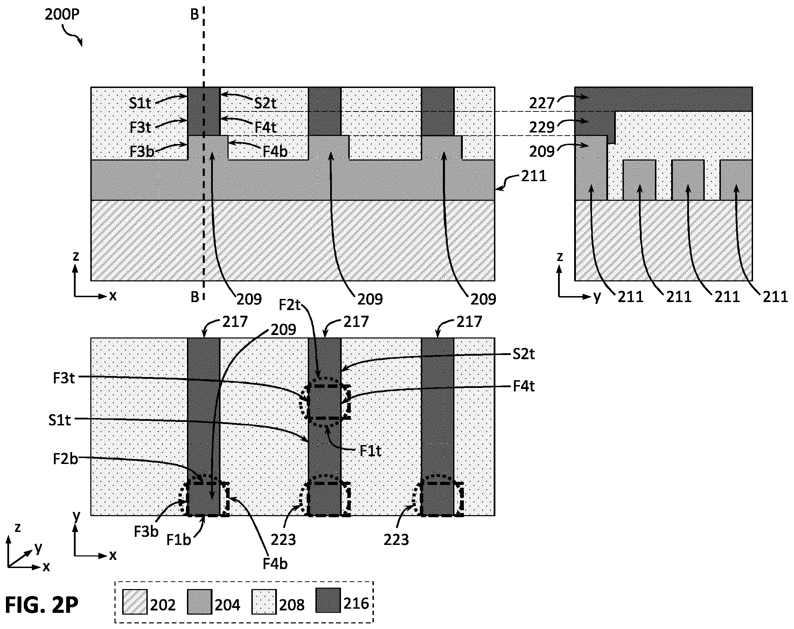

Further, references are made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense. For convenience, if a collection of drawings designated with different letters are present, e.g., FIGS. 2A-2P, such a collection may be referred to herein without the letters, e.g., as "FIG. 2."

In the drawings, some schematic illustrations of example structures of various devices and assemblies described herein may be shown with precise right angles and straight lines, this is simply for ease of illustration, and embodiments of these assemblies may be curved, rounded, or otherwise irregularly shaped as dictated by, and sometimes inevitable due to, the manufacturing processes used to fabricate semiconductor device assemblies. Therefore, it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Furthermore, although a certain number of a given element may be illustrated in some of the drawings (e.g., a certain number of bottom metal lines, a certain number of top metal lines, a certain number of stacked vias, etc.), this is simply for ease of illustration, and more, or less, than that number may be included in an IC structure with one or more stacked vias with bottom portions formed using subtractive patterning as described herein. Still further, various views shown in some of the drawings are intended to show relative arrangements of various elements therein. In other embodiments, various IC structures with one or more stacked vias with bottom portions formed using subtractive patterning as described herein, or portions thereof, may include other elements or components that are not illustrated (e.g., transistor portions, various components that may be in electrical contact with any of the metal lines, etc.). Inspection of layout and mask data and reverse engineering of parts of a device to reconstruct the circuit using e.g., optical microscopy, TEM, or SEM, and/or inspection of a cross-section of a device to detect the shape and the location of various device elements described herein using e.g., Physical Failure Analysis (PFA) would allow determination of presence of IC structures with one or more stacked vias with bottom portions formed using subtractive patterning as described herein.

Various operations may be described as multiple discrete actions or operations in turn, in a manner that is most helpful in understanding the claimed subject matter. However, the order of description should not be construed as to imply that these operations are necessarily order dependent. These operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side" to explain various features of the drawings, but these terms are simply for ease of discussion, and do not imply a desired or required orientation. The accompanying drawings are not necessarily drawn to scale. Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, various aspects of the illustrative implementations will be described using terms commonly employed by those skilled in the art to convey the substance of their work to others skilled in the art.

For example, a term "interconnect" may be used to describe any element formed of an electrically conductive material for providing electrical connectivity to one or more components associated with an IC or/and between various such components. In general, the "interconnect" may refer to both conductive lines/wires (also sometimes referred to as "lines" or "metal lines" or "trenches") and conductive vias (also sometimes referred to as "vias" or "metal vias"). In general, a term "conductive line" may be used to describe an electrically conductive element isolated by a dielectric material typically comprising an interlayer low-k dielectric that is provided within the plane of an IC chip. Such conductive lines are typically arranged in several levels, or several layers, of metallization stacks. On the other hand, the term "conductive via" may be used to describe an electrically conductive element that interconnects two or more conductive lines of different levels of a metallization stack. To that end, a via may be provided substantially perpendicularly to the plane of an IC chip or a support structure over which an IC structure is provided and may interconnect two conductive lines in adjacent levels or two conductive lines in not adjacent levels. A term "metallization stack" may be used to refer to a stack of one or more interconnects for providing connectivity to different circuit components of an IC chip.

In another example, if used, the terms "package" and "IC package" are synonymous, as are the terms "die" and "IC die," the term "insulating" means "electrically insulating," the term "conducting" means "electrically conducting," unless otherwise specified. Although certain elements may be referred to in the singular herein, such elements may include multiple subelements. For example, "an electrically conductive material" may include one or more electrically conductive materials.

In another example, if used, the terms "oxide," "carbide," "nitride," etc. refer to compounds containing, respectively, oxygen, carbon, nitrogen, etc., the term "high-k dielectric" refers to a material having a higher dielectric constant than silicon oxide, while the term "low-k dielectric" refers to a material having a lower dielectric constant than silicon oxide.

Furthermore, the term "connected" may be used to describe a direct electrical or magnetic connection between the things that are connected, without any intermediary devices, while the term "coupled" may be used to describe either a direct electrical or magnetic connection between the things that are connected, or an indirect connection through one or more passive or active intermediary devices. The term "circuit" may be used to describe one or more passive and/or active components that are arranged to cooperate with one another to provide a desired function.

The terms "substantially," "close," "approximately," "near," and "about," generally refer to being within +/- 20% of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/- 5-20% of a target value based on the context of a particular value as described herein or as known in the art.

### Example fabrication method

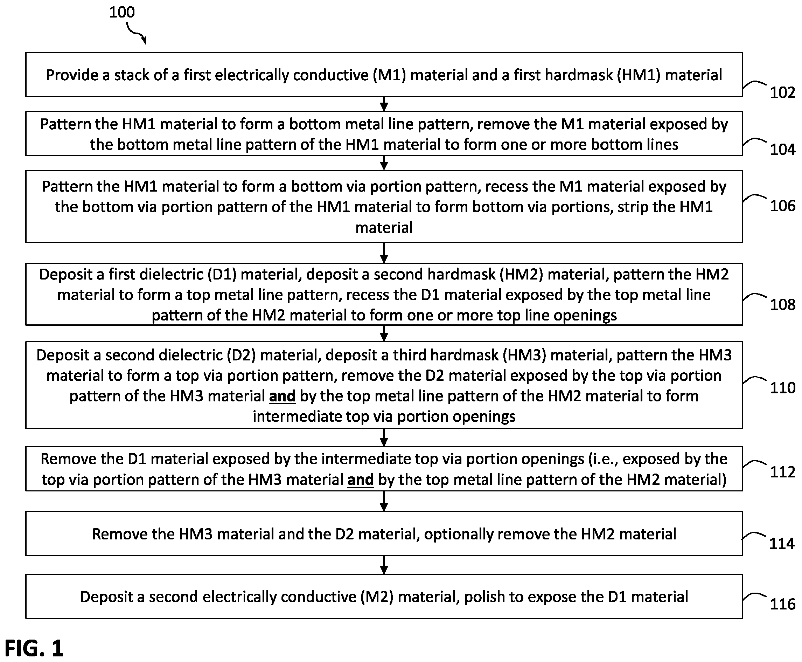

FIG. 1 provides a flow diagram of an example method of using subtractive patterning for forming bottom portions of stacked vias integrated in metallization stacks of IC structures, in accordance with some embodiments.

Although the operations of the method 100 are illustrated once each and in a particular order, the operations may be performed in any suitable order and repeated as desired. For example, one or more operations may be performed in parallel to manufacture, substantially simultaneously, multiple stacked vias with bottom portions formed using subtractive patterning within a single IC structure or multiple IC structures with stacked vias with bottom portions formed using subtractive patterning as described herein. In another example, the operations may be performed in a different order to reflect the structure of a particular device assembly in which one or more stacked vias with bottom portions formed using subtractive patterning as described herein will be included.

In addition, the example manufacturing method 100 may include other operations not specifically shown in FIG. 1, such as various cleaning or planarization operations as known in the art. For example, in some embodiments, a support structure, as well as layers of various other materials subsequently deposited thereon, may be cleaned prior to, after, or during any of the processes of the method 100 described herein, e.g., to remove oxides, surface-bound organic and metallic contaminants, as well as subsurface contamination. In some embodiments, cleaning may be carried out using e.g., a chemical solution (such as peroxide), and/or with ultraviolet (UV) radiation combined with ozone, and/or oxidizing the surface (e.g., using thermal oxidation) then removing the oxide (e.g., using hydrofluoric acid (HF)). In another example, the arrangements/devices described herein may be planarized prior to, after, or during any of the processes of the method 100 described herein, e.g., to remove overburden or excess materials. In some embodiments, planarization may be carried out using either wet or dry planarization processes, e.g., planarization be a chemical mechanical planarization (CMP), which may be understood as a process that utilizes a polishing surface, an abrasive and a slurry to remove the overburden and planarize the surface.

Various operations of the method 100 may be illustrated with reference to the example embodiments shown in FIGS. 2A-2P, illustrating top-down and cross-sectional side views for various stages in the manufacture of an example IC structure that includes one or more stacked vias with bottom portions formed using subtractive patterning, in accordance with some embodiments. In particular, the bottom illustration of each of FIGS. 2A-2P shows a top-down view of the IC structure (i.e., the view of an x-y plane of a reference coordinate system x-y-z shown at the bottom left corner of each of FIGS. 2A-2P), while the top illustration of each of FIGS. 2A-2H or the top left illustration of each of FIGS. 2I-2P shows a cross-section side view of the IC structure along a plane AA shown in the top-down view (i.e., the cross-section taken along an x-z plane of the reference coordinate system). Furthermore, the top right illustration of each of FIGS. 2I-2P shows a cross-section side view of the IC structure along a plane BB shown in the cross-section view of the x-z plane (i.e., the top right illustration of each of FIGS. 2I-2P shows a cross-section taken along a y-z plane of the reference coordinate system). In some of FIGS. 2A-2P the dashed lines of the planes AA and BB are not shown in order to not clutter the drawings, but the cross-sections shown remain as described above.

A number of elements referred to in the description of FIGS. 2A-2P with reference numerals are illustrated in these figures with different patterns, with a legend showing the correspondence between the reference numerals and patterns being provided at the bottom of each drawing page containing FIGS. 2A-2P. For example, the legend illustrates that FIGS. 2A-2P use different patterns to show a support structure 202, a first electrically conductive material 204, a first mask material 206, etc. Furthermore, although a certain number of a given element may be illustrated in some of FIGS. 2A-2P (e.g., a certain number of bottom metal lines, a certain number of top metal lines, and a certain number of stacked vias), this is simply for ease of illustration, and more, or less, than that number may be included in an IC structure fabricated according to the method 100. Still further, various views shown in FIGS. 2A-2P are intended to show relative arrangements of various elements therein. In other embodiments, various IC structures with one or more stacked vias with bottom portions formed using subtractive patterning, or portions thereof, may include other elements or components that are not illustrated (e.g., transistor portions, various components that may be in electrical contact with any of the bottom metal line, the top metal line, and the via in between, etc.).

Turning to FIG. 1A, the method 100 may begin with a process 102 that includes providing, over a support structure, a stack of a first electrically conductive material and a first mask material. An IC structure 200A, depicted in FIG. 2A, illustrates an example result of the process 102. As shown in FIG. 2A, the IC structure 200A may include a support structure 202 with a layer of a first electrically conductive (M1) material 204, and layer of a first mask material, e.g., a first hardmask (HM) material 206, over the M1 material 204.

In general, implementations of the disclosure may be formed or carried out on a substrate, such as a semiconductor substrate composed of semiconductor material systems including, for example, N-type or P-type materials systems. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V, group II-VI, or group IV materials.

In various embodiments, the support structure 202 may include any such substrate, possibly with some layers (e.g., lower level metallization layers) and/or devices already formed thereon (e.g., FEOL devices), not specifically shown in the present figures, providing a suitable surface for forming metallization stacks that may include one or more stacked vias with bottom portions formed using subtractive patterning for improved via integration in the BEOL.

In general, various electrically conductive materials described herein, e.g., the M1 material 204, may include one or more of any suitable electrically conductive materials (conductors). Such materials may include any suitable electrically conductive material, alloy, or a stack of multiple electrically conductive materials. In some embodiments, various electrically conductive materials described herein may include one or more metals or metal alloys, with metals such as copper, ruthenium, palladium, platinum, cobalt, nickel, molybdenum, hafnium, zirconium, titanium, tantalum, and aluminum. In some embodiments, various electrically conductive materials described herein may include one or more electrically conductive alloys, oxides (e.g., conductive metal oxides), carbides (e.g., hafnium carbide, zirconium carbide, titanium carbide, tantalum carbide, and aluminum carbide, tungsten, tungsten carbide), or nitrides (e.g., hafnium nitride, zirconium nitride, titanium nitride, tantalum nitride, and aluminum nitride) of one or more metals. Various electrically conductive materials described herein, e.g., the M1 material 204, may be deposited using a deposition technique such as, but not limited to, atomic layer deposition (ALD), chemical vapor deposition (CVD), physical vapor deposition (PVD) (e.g., evaporative deposition, magnetron sputtering, or e-beam deposition), plasma enhanced CVD (PECVD), or electroplating.

In general, various mask materials described herein, e.g., the HM1 material 206, may include one or more of any suitable materials that may be sufficiently etch-selective with respect to one or more surrounding materials in order to serve as a mask for patterning the one or more surrounding materials. As is known in the field of semiconductor manufacturing, etch selectivity between different materials may be used to ensure, e.g., that patterning using masks may be performed, where two materials may be described as "sufficiently etch-selective" if etchants used to etch one material do not substantially etch the other material, and vice versa. In various embodiments, the HM1 material 206 may include materials such as aluminum nitride, aluminum oxide, silicon nitride, or silicon carbon nitride, as long as the HM1 material 206 is sufficiently etch-selective with respect to the M1 material 204. Various mask materials described herein, e.g., the HM1 material 206, may be deposited using a deposition technique such as, but not limited to, spin-coating, dip-coating, ALD, CVD, or PVD.

A thickness of the M1 material 204 (in this case, a dimension measured along the z-axis of the example coordinate system shown in the present drawings) deposited in the process 102 may be substantially equal to a sum of a height of the bottom line to be formed of the M1 material 204 and a height of the bottom via portion of a stacked via to also be formed of the M1 material 204 in later fabrication processes. For example, in some embodiments, the thickness of the M1 material 204 may be between about 20 and 300 nanometers, including all values and ranges therein, e.g., between about 30 and 150 nanometers, or between about 35 and 100 nanometers. The thickness of the HM1 material 206 may be between about 2 and 50 nanometers, including all values and ranges therein, e.g., between about 3 and 30 nanometers, or between about 5 and 20 nanometers.

The method 100 may then proceed with a process 104 that includes patterning the HM1 material deposited in the process 102 to form what may be referred to as a "bottom metal line pattern," defining shapes and locations of one or more bottom metal lines to be formed of the M1 material deposited in the process 102, and further includes removing the M1 material exposed by the bottom metal line pattern to form one or more bottom metal lines. An IC structure 200B, depicted in FIG. 2B, illustrates an example result of the process 104.

As shown in FIG. 2B, the HM1 material 206 may be patterned to form a bottom metal line pattern of one or more (e.g., four) lines 203 of the HM1 material 206, which define top-down dimensions and locations of the future bottom lines, the lines 203 separated by openings 205 where the HM1 material 206 has been removed. In various embodiments, the bottom metal line pattern of the HM1 material 206 may be formed in the process 104 using any suitable etching technique (e.g., a dry etch, such as e.g., radio frequency (RF) reactive ion etch (RIE) or inductively coupled plasma (ICP) RIE) in combination with lithography (e.g., photolithography or electron-beam lithography) to define the locations and the sizes of the lines 203 and the openings 205 in the HM1 material 206. To that end, any suitable etch process for etching the HM1 material 206 without substantially etching the M1 material 204 may be used in the process 104 to define the lines 203. Once the lines 203 of the HM1 material 206 have been defined, the M1 material 204 not covered by the lines 203 (i.e., the M1 material 204 exposed by the openings 205 in the HM1 material 206) may be removed. To that end, any suitable etch process for etching the M1 material 204 without substantially etching the HM1 material 206 (e.g., any suitable direct metal etch process) may be used in the process 104. As a result of etching the M1 material 204, the support structure 202 may be exposed by the openings 205, as shown in FIG. 2B.

In some embodiments, the etches performed in the process 104 to etch, first, the HM1 material 206, and then the M1 material 204 may include anisotropic etches, using etchants in a form of, e.g., chemically active ionized gas (i.e., plasma) using e.g., bromine (Br) and chloride (CI) based chemistries. In some embodiments, during the etches of the process 104, the IC structure may be heated to elevated temperatures, e.g., to temperatures between about room temperature and 200 degrees Celsius, including all values and ranges therein, to promote that byproducts of the etch are made sufficiently volatile to be removed from the surface.

Next, the method 100 may then proceed with a process 106 that includes patterning the bottom metal line pattern of the HM1 material formed in the process 104 to form what may be referred to as a "bottom via portion pattern," defining shapes and locations of one or more bottom portions of future stacked vias, the bottom portions to be formed of the M1 material under the lines 203 formed in the process 104. The process 106 further includes recessing (i.e., partially removing) the M1 material exposed by the bottom via portion pattern to form one or more bottom via portions above bottom metal lines, and then removing the remaining portions of the HM1 material. FIGS. 2C-2E illustrate example results of the process 106.

An IC structure 200C, depicted in FIG. 2C, illustrates an example result of patterning the bottom metal line pattern of the HM1 material 206, formed in the process 104, to form a bottom via portion pattern the process 106. As shown in FIG. 2C, the bottom via portion pattern may include one or more islands 207 of the HM1 material 206, formed from what was remaining of the HM1 material 206 after the bottom metal line pattern was formed in the process 104. Only the three islands 207 in the bottom line 203 shown in the top-down view of FIG. 2C are shown, although in total four such islands are shown in the example of FIG. 2C (in other embodiments, the number of islands 207 may be any number equal to or greater than 1). The islands 207 define top-down dimensions and locations of the future bottom via portions of the stacked vias. As shown in FIG. 2C, the rest of the HM1 material 206 has been removed, exposing further portions of the M1 material 204. The HM1 material 206 may be patterned to form the islands 207 using any of processes as described for the process 104.

An IC structure 200D, depicted in FIG. 2D, illustrates an example result of recessing the M1 material exposed by the bottom via portion pattern to form one or more bottom via portions above bottom metal lines. As shown in FIG. 2D, the M1 material 204 that is not covered by the islands 207 may be recessed to form bottom via portions 209 under the islands 207 and bottom metal lines 211 below the bottom via portions 209. In some embodiments, the M1 material 204 that is not covered by the islands 207 may be recessed to a depth (a dimension measured along the z-axis of the example coordinate system shown) of, e.g., between about 5 and 80 nanometers, including all values and ranges therein, e.g., between about 5 and 50 nanometers, or between about 10 and 30 nanometers. In general, the depth of the recess of the M1 material 204 in the process 106 may be of any suitable value so that, as a result of the recess, the remaining portions of the M1 material 204 have sufficient height (a dimension measured along the z-axis of the example coordinate system shown) to form bottom metal lines 211, where the portions of the M1 material 204 covered by the islands 207 and, therefore, substantially protected from the recess of the process 106 form the bottom via portions 209. The depth of the recess of the M1 material 204 in the process 106 may then be the height of the bottom via portions 209. For example, a suitable height for the bottom metal lines 211 may be between about 10 and 200 nanometers, including all values and ranges therein, e.g., between about 20 and 150 nanometers, or between about 30 and 100 nanometers.

An IC structure 200E, depicted in FIG. 2E, illustrates an example result of removing the remaining portions of the HM1 material. As shown in FIG. 2E, once the islands 207 of the HM1 material 206 have been removed, the IC structure 200E may include one or more bottom metal lines, e.g., the bottom metal lines 211 as shown in FIG. 2E, of the M1 material 204, where at least one of the bottom metal lines 211 includes a protrusion extending upwards, which is the bottom via portion 209, e.g., as shown in FIG. 2E with four example bottom via portions 209 identified with dashed contours to indicate that the M1 material 204 in those portions extends higher than the M1 material 204 in the bottom metal lines 211.

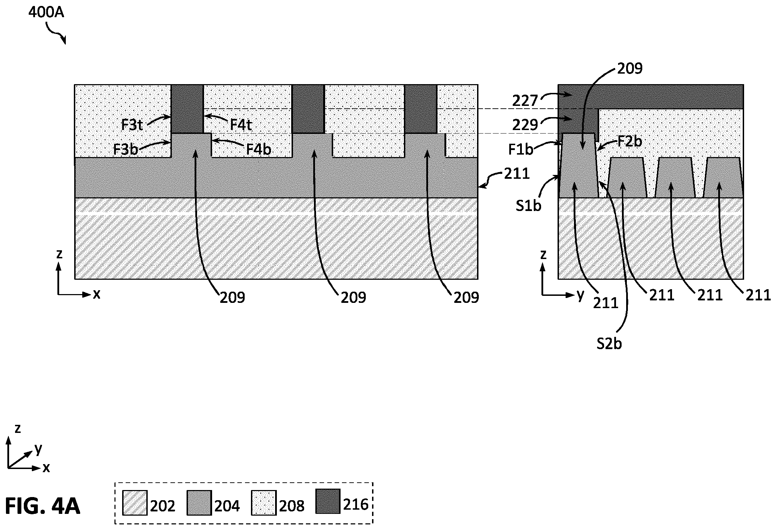

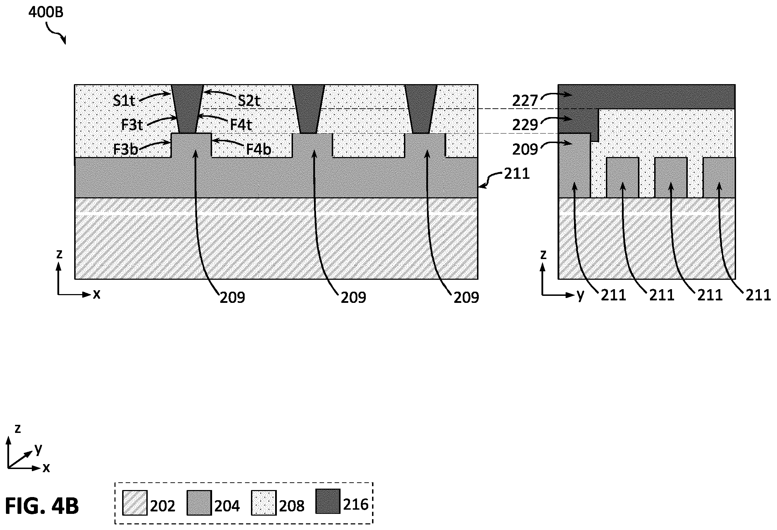

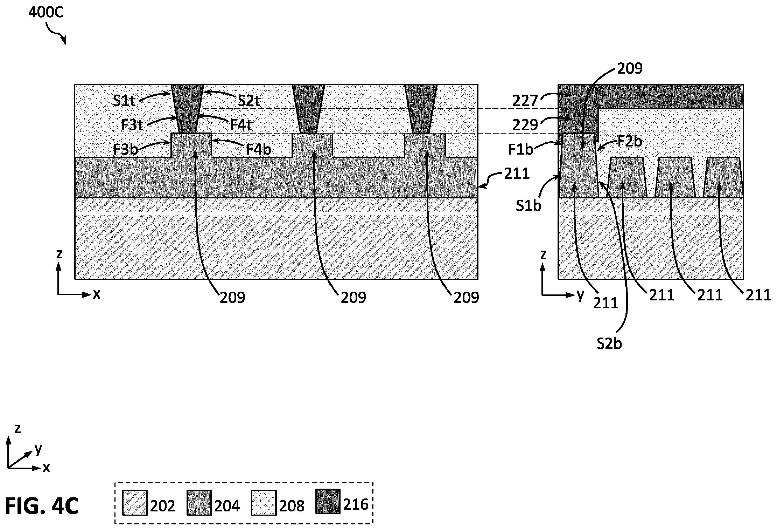

As a result of using subtractive patterning of the M1 material 204 to form the bottom metal lines 211 and the bottom via portions 209, as described above, the bottom via portions 209 may be self-aligned to the corresponding bottom metal lines 211 (i.e., of the bottom metal lines 211 from which the bottom via portions 209 are protruding), in a direction of the y-axis of the example coordinate system shown, wherein in a direction of the x-axis of the example coordinate system the bottom via portions 209 are just defined by the lithography of the HM1 material 206 when the islands 207 were formed. This may be explained with reference to one of the bottom via portions 209 for which first, second, third, and fourth side faces are labeled in FIG. 2E as, respectively, faces F1b, F2B, F3b, and F4b (where "b" stands for "bottom") and with reference to the bottom metal line 211 from which the labeled bottom via portion 209 extends (i.e., the bottom metal line 211 shown at the bottom of the top-down view of FIG 2E), for which first and second sidewalls are labeled in FIG. 2E as, respectively, S1b and S2b. Because the labeled bottom via portion 209 is formed as a portion of the M1 material 204 of the bottom metal line 211 that has not been recessed in the process 106, the faces F1b and F2b (i.e., two opposing faces of the bottom via portion 209) may be self-aligned with, respectively, the sidewalls S1b and S2b of the bottom metal line 211. In this context, self-alignment means that the face F1b may be self-aligned with the sidewall S1b, while the face F2b may be self-aligned with the sidewalls S2b. In other words, self-alignment may mean that the face F1b may be in a single plane with the sidewall S1b, while the face F2b may be in a single plane with the sidewall S2b. In some embodiments, these two planes may be substantially parallel to one another, and both perpendicular to the support structure 202, as is shown in the example shown in FIG. 2E (e.g., if the direct metal etch of the M1 material 204 is such that the sidewalls S1b and S2b of the bottom metal lines 211 are substantially vertical, i.e., perpendicular to the support structure 202). However, in other embodiments, the plane of the face F1b and the sidewalls S1b may be not parallel to the plane of the face F2b and the sidewalls S2b, e.g., if the cross-section of the bottom metal line 211 in an y-z plane is not a rectangle but a trapezoid (described in greater detail below, with reference to FIG. 4). Whether parallel or not, in various embodiments, the opposing faces F1b and F2b of the bottom via portion 209 may be substantially flat (i.e., each belonging to a single plane), which is also a consequence of the direct metal etch/subtractive patterning used to form the bottom via portion 209. On the other hand, the other two opposing faces of the bottom via portion 209, faces F3b and F4b, are not self-aligned to anything and are defined by the lithography of the HM1 material 206 to form the island 207 under which the bottom via portion 209 was formed.

The method 100 may then proceed with a process 108 that includes depositing a first dielectric (D1) material, depositing a second hardmask (HM2) material, patterning the HM2 material to form a top metal line pattern, and recessing (i.e., partially removing) the D1 material exposed by the top metal line pattern of the HM2 material to form one or more top line openings. FIGS. 2F-2I illustrate example results of the process 108.

An IC structure 200F, depicted in FIG. 2F, illustrates an example result of depositing a D1 material 208 over the bottom metal lines 211 and the bottom via portions 209 formed in the process 106. The D1 material 208 may include any material suitable for enclosing sidewalls of the stacked vias described herein. In some embodiments, the D1 material 208 may be a low-k dielectric material. Examples of the low-k dielectric materials that may be used as the D1 material 208 include, but are not limited to, silicon dioxide, carbon-doped oxide, silicon nitride, fused silica glass (FSG), and organosilicates such as silsesquioxane, siloxane, and organosilicate glass. Other examples of low-k dielectric materials that may be used as the D1 material 208 include organic polymers such as polyimide, benzocyclobutene, polynorbornenes, perfluorocyclobutane, or polytetrafluoroethylene (PTFE). Still other examples of low-k dielectric materials that may be used as the D1 material 208 include silicon-based polymeric dielectrics such as hydrogen silsesquioxane (HSQ) and methylsilsesquioxane (MSQ). Other examples of low-k materials that may be used in the D1 material 208 include various porous dielectric materials, such as for example porous silicon dioxide or porous carbon-doped silicon dioxide, where voids or pores are created in a dielectric in order to reduce the overall dielectric constant of the material, since voids or pores can have a dielectric constant of nearly 1. The D1 material 208 may be deposited in the process 108 using a technique such as spin-coating, dip-coating, ALD, CVD, or PVD.

A thickness of the D1 material 208 (in this case, a dimension measured along the z-axis of the example coordinate system shown in the present drawings) deposited as a result of the process 108 may be substantially equal to a sum of a height of the top line to be formed in a later fabrication process, a height of the top via portion of the stacked via also to be formed in a later fabrication process, and, if the thickness of the D1 material 208 is measured from the top of the bottom metal line 211, a height of the bottom via portion 209 of the stacked via. If the thickness of the D1 material 208 is measured from the top of the bottom via portion 209, then the thickness may be substantially equal to the sum of the height of the top line to be formed in a later fabrication process and the height of the top via portion of the stacked via also to be formed in a later fabrication process. For example, in some embodiments, the thickness of the D1 material 208, measured from the top of the bottom via portion(s) 209, may be between about 20 and 300 nanometers, including all values and ranges therein, e.g., between about 30 and 150 nanometers, or between about 50 and 100 nanometers.

An IC structure 200G, depicted in FIG. 2G, illustrates an example result of depositing a HM2 material 210 over the D1 material 208. In various embodiments, the HM2 material 210 may include any suitable material that is sufficiently etch-selective with respect to the D1 material 208. The HM2 material 210 may include any of the materials described with reference to the HM1 material 206, where the HM1 material 206 and the HM2 material 210 may have the same or different material compositions. The HM2 material 210 may be deposited in the process 108 using any of the deposition techniques described with reference to the HM1 material 206 and may have a thickness comparable to that described for the HM1 material 206.

An IC structure 200H, depicted in FIG. 2H, illustrates an example result of patterning the HM2 material to form a top metal line pattern of one or more (e.g., three) openings 213 in the HM2 material 210, which openings define top-down dimensions and locations of the future top lines. In various embodiments, the top metal line pattern of the HM2 material 210 may be formed in the process 108 using any suitable etching technique, such as those described with reference to patterning of the HM1 material 206. As can be seen in FIG. 2H, the openings 213 may not be perfectly aligned to the bottom via portions 209 because they are not formed by a self-aligned process but, rather, are defined by lithography of the HM2 material 210 and, therefore, may be subject to offsets (edge placement errors) with respect to the underlying bottom via portions 209. The outlines of the underlying bottom via portions 209 are indicated in the top-down view of FIG. 2H with dashed lines. For example, as is shown in the cross-section view of FIG. 2H for one of the openings 213, the opening 213 may be offset by a distance 215 with respect to the fourth face F4b, defined above, of the bottom via portion 209. Although not specifically shown in FIG. 2H, there may be similar offset with respect to the third face F3b, defined above, of the bottom via portion 209, where the two offsets may be of the same or different values, and may be either positive values (i.e., the opening 213 extends over and beyond the respective third or fourth face of the bottom via portion 209) or negative values (i.e., the opening 213 is smaller than what is shown in FIG. 2H and does not reach the respective third or fourth face of the bottom via portion 209). Different openings 213 may have different such offsets with respect to the third and/or fourth faces of the respective bottom via portions 209.

An IC structure 200I, depicted in FIG. 2I, illustrates an example result of recessing the D1 material 208 exposed by the top metal line pattern of the HM2 material 210, to form one or more top metal line openings 217 in the D1 material 208. The top metal line openings 217 may be formed by performing a suitable etch process (e.g., any of the etch processes described above) to partially remove the D1 material 208 exposed in the openings 213 in the HM2 material 210, without substantially removing the HM2 material 210. Since the openings 213 serve as a mask for recessing the D1 material 208, the top metal line openings 217 are self-aligned with the openings 213 in the x-y plane. Consequently, any misalignments of the openings 213 with respect to any of the bottom via portions 209 carry over (i.e., transfer) to corresponding misalignments of the top metal line openings 217. The depth of the recess in the D1 material 208 in the top metal line openings 217 (a dimension measured along the z-axis of the example coordinate system shown) may be of any suitable value for a height of the top metal lines. For example, a suitable height for the future top metal lines (and, therefore, of the depth of the recess in the D1 material 208 in the top metal line openings 217, formed in the process 108) may be between about 10 and 200 nanometers, including all values and ranges therein, e.g., between about 20 and 150 nanometers, or between about 30 and 100 nanometers. FIG. 2I further illustrates a second cross-section view of an y-z plane BB, next to the cross-section view of the x-z plane AA, with two dashed lines between the two views indicating alignment between the views. In particular, the y-z plane view clearly shows four different bottom metal lines 211, as well as illustrates that the bottom via portion 209 provided over one of the bottom metal lines 211 is continuous with that bottom metal line, because of the subtractive patterning used to form it.

The method 100 may then proceed with a process 110 that includes depositing a second dielectric (D2) material, depositing a third hardmask (HM3) material, patterning the HM3 material to form a top via portion pattern, and removing the D2 material exposed by the top via portion pattern of the HM3 material as well as by the top metal line pattern of the HM2 material to form one or more intermediate top via portion openings. FIGS. 2J-2L illustrate example results of the process 110.

An IC structure 200J, depicted in FIG. 2J, illustrates an example result of depositing a D2 material 212 over the IC structure formed in the process 108, including in and over the top metal line openings 217, and then depositing a HM3 material 214 over the D2 material 212. The D2 material 212 may include any suitable material that is sufficiently etch-selective with respect to the HM3 material 214 and the HM2 material 210 and may include any of the materials described with reference to the D1 material 208. The D2 material 212 may be deposited in the process 110 using a technique such as spin-coating, dip-coating, ALD, CVD, or PVD. A thickness of the D2 material 212 (in this case, a dimension measured along the z-axis of the example coordinate system shown in the present drawings) deposited as a result of the process 110 is not that important because all of the D2 material 212 will be subsequently removed. For example, in some embodiments, the thickness of the D2 material 212, measured from the top of the HM2 material 210, may be between about 2 and 200 nanometers, including all values and ranges therein, e.g., between about 5 and 100 nanometers, or between about 10 and 50 nanometers. In various embodiments, the HM3 material 214 may include any suitable material that is sufficiently etch-selective with respect to the D2 material 212. The HM3 material 214 may include any of the materials described with reference to the HM1 material 206, where the HM1 material 206, the HM2 material 210, and the HM3 material 214 may have the same or different material compositions. The HM3 material 214 may be deposited in the process 110 using any of the deposition techniques described with reference to the HM1 material 206 and may have a thickness comparable to that described for the HM1 material 206.

An IC structure 200K, depicted in FIG. 2K, illustrates an example result of patterning the HM3 material 214 to form a top via portion pattern of one or more (e.g., four) openings 219 in the HM3 material 214, which openings define top-down dimensions and locations of the future top via portions. In various embodiments, the top via portion pattern of the HM3 material 214 may be formed in the process 110 using any suitable etching technique, such as those described with reference to patterning of the HM1 material 206. The top via portion openings 219 are intended to land substantially on the bottom via portions 209. However, as can be seen in FIG. 2K, the openings 219 may not be perfectly aligned to the underlying bottom via portions 209 (the outlines of which are shown in the top-down view of FIG. 2K with rectangular dashed contours, same as in FIG. 2J) as well as the underlying top metal line openings 217 (the outlines of which are shown in the top-down view of FIG. 2K with vertical dotted lines, same as in FIG. 2J) because they are not formed by a self-aligned process but, rather, are defined by lithography of the HM3 material 214 and, therefore, may be subject to offsets (edge placement errors) with respect to the underlying top metal line openings 217 and the underlying bottom via portions 209. It is also possible that the alignment of the lithography to form the openings 219 with respect to the bottom via portions 209 is reasonable, but the openings 219 are sized for an area (e.g., a diameter) larger than the width of the bottom metal lines 211 over which the bottom via portions 209 are provided (the width being a dimension measured in the direction of the y-axis in this case), as is shown in the top-down view of FIG. 2K. The openings 219 are shown in the top-down view of FIG. 2K as substantially circular openings, however, in other embodiments, they shape may be different.

An IC structure 200L, depicted in FIG. 2L, illustrates an example result of removing the D2 material 212 exposed by the openings 219 of the top via portion pattern of the HM3 material 214 as well as by the openings 213 of the top metal line pattern of the HM2 material 210, to form one or more intermediate top via portion openings 221 in the D2 material 212. The intermediate top via portion openings 221 may be formed by performing a suitable etch process (e.g., any of the etch processes described above) to remove the D2 material 212 exposed by the openings 219 in the HM3 material 214 and the openings 213 in the HM2 material 210, without substantially removing the HM3 material 214 and the HM2 material 210. Since the openings 219 serve as a mask for recessing the D2 material 212 until the top of the HM2 material 210, the intermediate top via portion openings 221 are self-aligned with the openings 219 in the x-y plane until the top of the HM2 material 210. Consequently, any misalignments of the openings 219 with respect to any of the bottom via portions 209 carry over (i.e., transfer) to corresponding misalignments of the intermediate top via portion openings 221. After that, the openings 213 in the HM2 material 210 serve as a mask for removing the rest of the D2 material 212 that was deposited into the top metal line openings 217 until the D1 material 208 is exposed at the bottom of the top metal line openings 217. Thus, below the HM2 material 210, the intermediate top via portion openings 221 are self-aligned with the openings 213 in the x-y plane. The top-down view of FIG. 2L illustrates that the openings 221 expose not only the D1 material 208 at the bottom of the openings, aligned with the top metal line openings 217, but also expose the HM2 material 210 that was patterned to define the top metal line openings 217.

The method 100 may then proceed with a process 112 that includes removing the D1 material exposed by the intermediate top via portion openings 221 formed in the process 110 (i.e., exposed by the openings 219 of the top via portion pattern of the HM3 material 214 and by the openings 213 of the top metal line pattern of the HM2 material 210) to form top via portion openings. An IC structure 200M, depicted in FIG. 2M, illustrates an example result of the process 112. As shown in FIG. 2M, top via portion openings 223 are formed as a result of extending the intermediate top via portion openings 221 into the D1 material 208 until the M1 material 204 of the bottom via portions 209 is exposed at the bottom of the openings 223. The top-down view of FIG. 2M illustrates that the openings 223 expose not only the M1 material 204 of the bottom via portions 209 at the bottom of the openings 223, but also the D1 material 208 surrounding the bottom via portions 209, but also expose the HM2 material 210 that was patterned to define the top metal line openings 217. The exposure of the openings 223 is aligned with the intermediate top via portion openings 221. As a result of this processing, any misalignment in the top via portion openings 219 in the HM3 material 214 may be carried into the D1 material 208, but only in the y-axis direction and not in the x-axis direction because the openings 213 in the HM2 material 210 preserve the alignment in the x-axis direction. An example misalignment of one of the openings 223 in the y-axis direction is shown in the cross-section of the y-z plane BB shown in FIG. 2M (i.e., the cross-section on the right side), illustrating that there may be over-etch into the D1 material 208 surrounding the bottom via portion 209. Because dielectric and electrically conductive materials are typically sufficiently etch-selective, the etch of the D1 material 208 in the process 112 does not substantially etch the M1 material 204 of the bottom via portions 209 exposed at the bottom of the openings 223, while some of the D1 material 208 surrounding the bottom via portions 209 may be over-etched. Horizontal lines between the two cross-section views shown in FIG. 2M illustrate alignment between these views.

Next, the method 100 may include a process 114 that includes remove all of the HM3 material 214 and all of the D2 material 212. Optionally, the HM2 material 210 may be removed as well in the process 114. An IC structure 200N, depicted in FIG. 2N, illustrates an example result of the process 114 for the optional embodiment where the HM2 material 210 is removed as well, however, in other embodiments of the IC structure 200N, the HM2 material 210 of the IC structure 200M may be present. As shown in FIG. 2N, now that the HM3 material 214 and the D2 material 212 have been removed, the top metal line openings 217 in the D1 material 208 are opened again (the outlines of which are shown with vertical dash-dotted lines in the top-down view of FIG. 2N). Furthermore, at some portions of the top metal line openings 217 in the D1 material 208 there are further openings 223 for the top via portions, as described above. The cross-section of the y-z plane BB shown in FIG. 2N (i.e., the cross-section on the right side), clearly illustrates how the top metal line opening 217 continues into the top via portion opening 223.

The method 100 may conclude with a process 116 that includes depositing a second electrically conductive (M2) material into the openings 217 and 223 and polishing the M2 material to expose the D1 material. FIGS. 2O-2P illustrate example results of the process 116.

An IC structure 200O, depicted in FIG. 2O, illustrates an example result of depositing an M2 material 216 into the openings 217 and 223 that were exposed in the process 114. The M2 material 216 may included any of the materials described with reference to the M1 material 204 and may be deposited using similar deposition techniques. In various embodiments, the exact material compositions of the M2 material 216 and the M1 material 204 may be the same or different. If the HM2 material 210 was not removed in the process 214, then the IC structure 2000 would include the HM2 material 210 (now not shown in FIG. 2O).

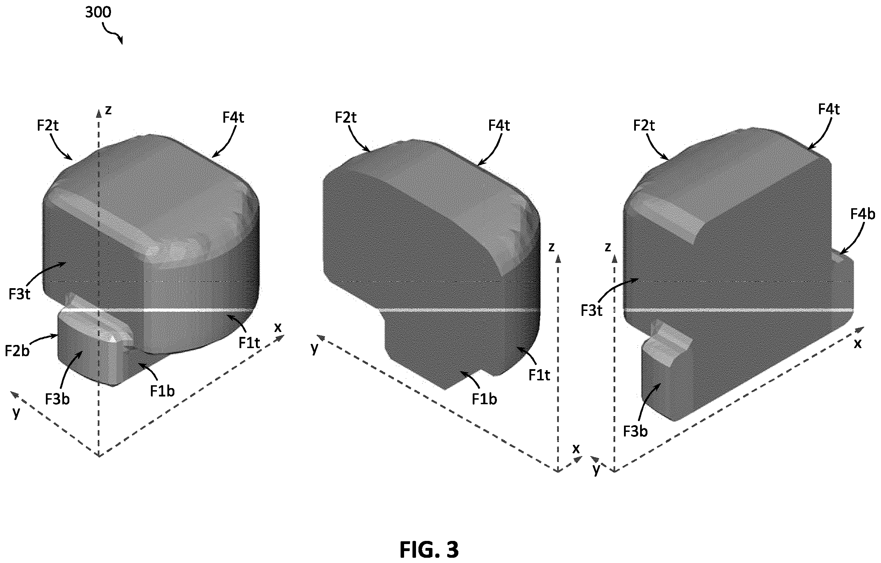

An IC structure 200P, depicted in FIG. 2P, illustrates an example result of polishing the M2 material 216 to expose the D1 material 208 (e.g., polishing the M2 material 216 until it is flush with the D1 material 208). As shown in FIG. 2P, as a result of polishing the M2 material 216 in this manner, the M2 material 216 only remains in the top metal line openings 217, thus forming top metal lines 227, as well as in the top via portion openings 223, thus forming top via portions 229. The outlines of the openings 223 as shown in the top-down view of FIG. 2P with dotted circles, as in FIGS. 2M-2O. The outlines of the underlying bottom via portions 209 are shown in the top-down view of FIG. 2P with dashed rectangles, as in FIGS. 2E, 2H, 2J, and 2K. As a result of depositing the M2 material 216 into the top via portion openings 223, the M2 material 216 in the openings 223 may be coupled to the M1 material 204 of the bottom via portions 209, thus providing electrical coupling between each top via portion 229 and a corresponding (i.e., underlying) bottom via portion 209, forming stacked vias, one example of which is shown in FIG. 3. As a result of the M2 material 216 also being deposited in the top metal line openings 217, electrical coupling between the top metal lines 227 and corresponding (i.e., underlying) top via portions 229 may be realized.

Faces F1b-F4b for one example bottom via portion 209 are labeled in the top-down view of FIG. 2P in the same manner as they were shown in FIG. 2E. Furthermore, faces F1t-F4t (where "t" stands for "top") for one example top via portion 229 are labeled in the top-down view of FIG. 2P in a manner that is analogous to that of the faces F1b-F4b for the bottom via portions 209. The faces F1t-F4t are labeled in the top-down view of FIG. 2P for an example top via portion 229 that is different from that corresponding to the example bottom via portion 209 for which the faces F1b-F4b are labeled, but that is only in order to not clutter the drawing, and analogous labeling of the faces F1t-F4t holds for all other top via portions 229 shown in FIG. 2P. In the following descriptions, it is assumed that the first face F1t of a given top via portion 229 is the face that faces the same direction as the first face F1b of the corresponding bottom via portion 209 to which the top via portion 229 is coupled, the second face F2t of a given top via portion 229 is the face that faces the same direction as the second face F2b of the corresponding bottom via portion 209 to which the top via portion 229 is coupled, the third face F3t of a given top via portion 229 is the face that faces the same direction as the third face F3b of the corresponding bottom via portion 209 to which the top via portion 229 is coupled, and the fourth face F4t of a given top via portion 229 is the face that faces the same direction as the fourth face F4b of the corresponding bottom via portion 209 to which the top via portion 229 is coupled, as shown in FIG. 2P. FIG. 3 provides various views, as could be seen in a real-life device, of an example stacked via 300 where one example bottom via portion 209 is coupled to a corresponding example top via portion 229. FIG. 3 illustrates the coordinate system used in the illustrations of FIG. 2, as well as labels faces F1b-F4b and F1t-F4t whenever possible. The left illustration of FIG. 3 provides a perspective view of the stacked via 300, the middle illustration of FIG. 3 provides a cross-section of the stacked via 300 along an y-z plane substantially across the stacked via 300 (e.g., similar to the cross-section along the plane BB, shown in FIG. 2), and the right illustration of FIG. 3 provides a cross-section of the stacked via 300 along a x-z plane substantially across the stacked via 300 (e.g., similar to the cross-section along the plane AA, shown in FIG. 2).

As a result of using Damascene processing as described above to form the top metal lines 227 and the top via portions 229, the top via portions 229 may be self-aligned to the corresponding top metal lines 227 (i.e., of the top metal lines 227 from which the openings 223 for the top via portions 229 were formed), in a direction of the x-axis of the example coordinate system shown, wherein in a direction of the y-axis of the example coordinate system the top via portions 229 are just defined by the lithography of the HM3 material 214 when the openings 219 were formed as shown in FIG. 2K. This may be explained with reference to one of the top via portions 229 for which first, second, third, and fourth side faces are labeled in FIG. 2P (and in FIG. 3) as, respectively, faces F1t, F2t, F3t, and F4t and with reference to one of the top metal lines 227, shown in the top-down view of FIG. 2P, from which the labeled top via portion 229 extends (i.e., the top metal line 227 shown in the middle of the top-down view of FIG 2P), for which first and second sidewalls are labeled in FIG. 2P as, respectively, S1t and S2t. Because the labeled top via portion 229 is formed as the opening 223 that was extended from the opening 217 for the top metal line 227, the faces F3t and F4t (i.e., two opposing faces of the top via portion 229) may be self-aligned with, respectively, the sidewalls S1t and S2t of the top metal line 227. In this context, self-alignment means that the face F3t may be self-aligned with the sidewall S1t, while the face F4t may be self-aligned with the sidewalls S2t. In other words, self-alignment may mean that the face F3t may be in a single plane with the sidewall S1t, while the face F4t may be in a single plane with the sidewall S2t. In some embodiments, these two planes may be substantially parallel to one another, and both perpendicular to the support structure 202, as is shown in the example shown in FIG. 2P (e.g., if the etch of the D1 material 208 is such that the sidewalls S1t and S2t of the top metal lines 227 are substantially vertical, i.e., perpendicular to the support structure 202). However, in other embodiments, the plane of the face F3t and the sidewalls S1t may be not parallel to the plane of the face F4t and the sidewalls S2t, e.g., if the cross-section of the top metal line 227 in an x-z plane is not a rectangle but a trapezoid (described in greater detail below, with reference to FIG. 4). Whether parallel or not, in various embodiments, the opposing faces F3t and F4t of the top via portion 229 may be substantially flat (i.e., each belonging to a single plane). On the other hand, the other two opposing faces of the top via portion 229, faces F1t and F2t, are not self-aligned to anything and are defined by the lithography of the HM3 material 214 to form the openings 219 through which eventually the openings 223 for the top via portions 229 were formed.

The principles described above are also illustrated in FIG. 3, where the example stacked via 300 includes features characteristic of the use of the method 100. For example, FIG. 3 illustrates that the faces F1b and F2b are substantially flat, which is a result of the bottom via portion 209 being self-aligned in the y-axis direction to the underlying bottom metal line 211. On the other hand, the faces F3b and F4b may be not flat (i.e., each face does not belong to a single respective plane), as illustrated in FIG. 3, because the bottom via portion 209 is not self-aligned to anything in the x-axis direction and the shape of the faces F3b and F4b is defined by the direct metal etch process used to recess the M1 material 204 to form the bottom via portion 209. This means that, in general, the face F3b of the bottom via portion 209 may, but does not have to, be in a single plane with the sidewall S1t of the top metal line 227 and/or the face F4b of the bottom via portion 209 may, but does not have to, be in a single plane with the sidewall S2t of the top metal line 227. Similarly, FIG. 3 illustrates that the faces F3t and F4t are substantially flat, which is a result of the top via portion 229 being self-aligned in the x-axis direction to the top metal line 227 above it. On the other hand, the faces F1t and F2t may be not flat, as illustrated in FIG. 3, because the top via portion 229 is not self-aligned to anything in the y-axis direction and the shape of the faces F1t and F2t is defined by the etch process used to remove the D1 material 208 through the openings 223, as described above. This means that, in general, the face F1t of the top via portion 229 may, but does not have to, be in a single plane with the sidewall S1b of the bottom metal line 211 and/or the face F2t of the top via portion 229 may, but does not have to, be in a single plane with the sidewall S2b of the bottom metal line 211.

FIG. 3 further illustrates that, in the invention, a distance between the faces F1b and F2b is smaller than a distance between the faces F1t and F2t (both distances measured along the y-axis of the example coordinate system shown). This is also illustrated in the y-z cross-section of FIG. 2P and explained with reference to the misalignment of the openings 219 of FIG. 2K. FIG. 3 also illustrates that, in some embodiments, a distance between the faces F3t and F4t may be smaller than a distance between the faces F3b and F4b (both distances measured along the x-axis of the example coordinate system shown). This is also illustrated in the x-z cross-section of FIG. 2P and explained with reference to the misalignment of the openings 213 of FIG. 2H.

### Variations and implementations

The IC structures illustrated in and described with reference to FIG. 2 do not represent an exhaustive set of arrangements in which one or more stacked vias with bottom portions formed using subtractive patterning as described herein may be integrated, but merely provide examples of such arrangements.

For example, although not specifically shown in the present drawings, in further embodiments, one or more barrier materials may be implemented around portions of electrically conductive materials (e.g., enclosing sidewalls of any of the bottom metal lines 211, the top metal lines 227, the bottom via portions 209, and the top via portions 229), to prevent diffusion of the electrically conductive material of these portions to the surrounding dielectric/insulating materials.

In another example, although also not specifically shown in the present drawings, in further embodiments, there may be a layer of interface material between the M1 material 204 of the bottom via portion 209 and the M2 material 216 of the top via portion 229.

In yet another example, although FIGS. 2 and 3 illustrate the self-aligned faces of the bottom via portion 209 and the top via portion 229 to be substantially parallel to one another and, therefore, substantially perpendicular to the support structure 202, in other embodiments, these faces may be tilted (i.e., be not at a 90 degree angle to the support structure 202). Some examples of this are shown in FIGS. 4A-4C, illustrating cross-sectional side views of alternative embodiments of the IC structure manufactured according to the method of FIG. 1, in accordance with some embodiments. Each of FIGS. 4A-4C provide, on the right side, a cross-sectional view of an IC structure along the x-z plane AA, and, on the left side, a cross-sectional view of the IC structure along the x-y plane BB, as described above (i.e., these cross-sectional views are analogous to those of FIG. 2, e.g., as shown in FIG. 2P, but for alternative embodiments), using the same patterns for different materials as those described above.

FIG. 4A illustrates an embodiment of an IC structure 400A which may be substantially the same as the IC structure 200P except that, as a result of the subtractive patterning (direct metal etch) of the M1 material 204 used to form the bottom metal lines 211 and the bottom via portions 209, cross-sections of the y-z plane of the M1 material 204 may be substantially trapezoidal, as can be seen in the y-z cross-section of FIG. 4A. This is not seen in the x-z cross-sections (because the bottom metal lines 211 have a length measured along the x-axis of the example coordinate system shown), so the x-z cross-section of the IC structure 400A is the same as that of the IC structure 200P. FIG. 4A illustrates that, in some embodiments, the bottom via portions 209 fabricated using the method 100 may be such that the width of the bottom via portions 209 at the top (i.e., farther away from the support structure 202) is smaller than the width of the bottom via portions 209 at the bottom (i.e., closer to the support structure 202), where both of these widths are measured along the y-axis of the example coordinate system shown). Similarly, the bottom metal lines 211 fabricated using the method 100 may be such that the width of the bottom metal lines 211 at the top (i.e., farther away from the support structure 202) is smaller than the width of the bottom metal lines 211 at the bottom (i.e., closer to the support structure 202), where both of these widths are measured along the y-axis of the example coordinate system shown). In such embodiments, the y-axis width of the bottom via portions 209 at the top may be defined by the y-axis width of the lines 203 of the HM1 material 206 (e.g., as shown in FIG. 2B), and may gradually increase when measured closer to the support structure 202. As can be seen in the y-z cross-section of FIG. 4A, in such embodiments, the faces F1b and F2b may still be substantially flat (as was explained with reference to FIGS. 2 and 3), which is a result of the bottom via portion 209 being self-aligned in the y-axis direction to the underlying bottom metal line 211. Similarly, the sidewalls S1b and S2b may be substantially flat. Furthermore, the face F1b may still be in a single plane with the sidewall S1b and the face F2b may still be in a single plane with the sidewall S2b, as described above, except that now these planes may be planes which are not parallel to one another because they are not perpendicular to the support structure 202.

FIG. 4B illustrates an embodiment of an IC structure 400B which may be substantially the same as the IC structure 200P except that, as a result of the Damascene fabrication used to form the top metal lines 227 and the top via portions 229, cross-sections of the x-z plane of the M2 material 216 may be substantially trapezoidal, as can be seen in the x-z cross-section of FIG. 4B. This is not seen in the y-z cross-sections (because the top metal lines 227 have a length measured along the y-axis of the example coordinate system shown), so the y-z cross-section of the IC structure 400B is the same as that of the IC structure 200P. FIG. 4B illustrates that, in some embodiments, the top via portions 229 fabricated using the method 100 may be such that the width of the top via portions 229 at the top (i.e., farther away from the support structure 202) is larger than the width of the top via portions 229 at the bottom (i.e., closer to the support structure 202), where both of these widths are measured along the x-axis of the example coordinate system shown). Similarly, the top metal lines 227 fabricated using the method 100 may be such that the width of the top metal lines 227 at the top (i.e., farther away from the support structure 202) is greater than the width of the top metal lines 227 at the bottom (i.e., closer to the support structure 202), where both of these widths are measured along the x-axis of the example coordinate system shown). In such embodiments, the x-axis width of the top metal lines 227 at the top may be defined by the x-axis width of the openings 217 (e.g., as shown in FIG. 2N), and may gradually decrease when measured closer to the support structure 202. As can be seen in the x-z cross-section of FIG. 4B, in such embodiments, the faces F3t and F4t may still be substantially flat (as was explained with reference to FIGS. 2 and 3), which is a result of the top via portion 229 being self-aligned in the x-axis direction to the top metal line 227 above it. Similarly, the sidewalls S1t and S2t may be substantially flat. Furthermore, the face F3t may still be in a single plane with the sidewall S1t and the face F4t may still be in a single plane with the sidewall S2t, as described above, except that now these planes may be planes which are not parallel to one another because they are not perpendicular to the support structure 202.

FIG. 4C illustrates an embodiment of an IC structure 400C which may be substantially the same as the IC structure 200P except that, as a result of the subtractive patterning (direct metal etch) of the M1 material 204 used to form the bottom metal lines 211 and the bottom via portions 209, cross-sections of the y-z plane of the M1 material 204 may be substantially trapezoidal, as can be seen in the y-z cross-section of FIG. 4C, while, as a result of the Damascene fabrication used to form the top metal lines 227 and the top via portions 229, cross-sections of the x-z plane of the M2 material 216 may be substantially trapezoidal, as can be seen in the x-z cross-section of FIG. 4C. Thus, the IC structure 400C is a combination of embodiments of the IC structure 400A and the IC structure 400B, as described above (which descriptions are not repeated here in the interests of brevity).

### Example devices

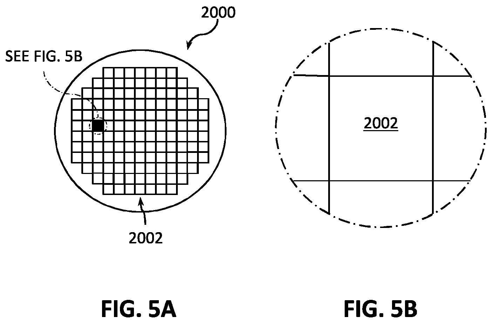

The IC structures with one or more stacked vias with bottom portions formed using subtractive patterning, disclosed herein, may be included in any suitable electronic device. For example, in various embodiments, the IC structures as described herein may be a part of at least one of a memory device, a computing device, a wearable device, a handheld electronic device, and a wireless communications device. FIGS. 5-8 illustrate various examples of devices that may include one or more stacked vias with bottom portions formed using subtractive patterning disclosed herein.

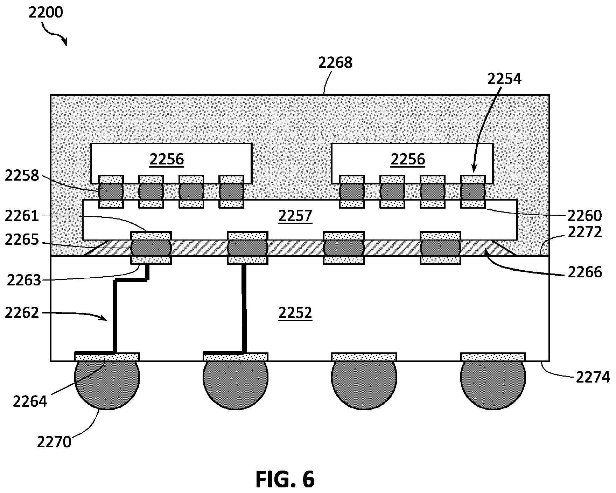

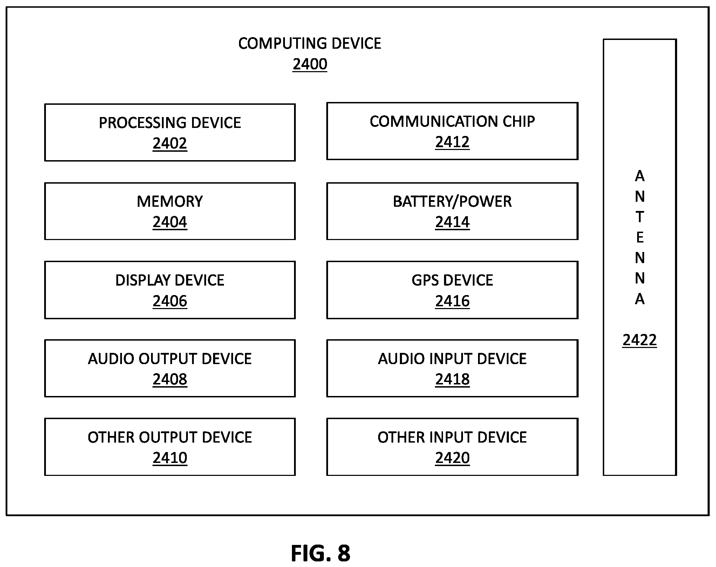

FIGS. 5A-5B are top views of a wafer 2000 and dies 2002 that may include one or more stacked vias with bottom portions formed using subtractive patterning in accordance with any of the embodiments disclosed herein. In some embodiments, the dies 2002 may be included in an IC package, in accordance with any of the embodiments disclosed herein. For example, any of the dies 2002 may serve as any of the dies 2256 in an IC package 2200 shown in FIG. 6. The wafer 2000 may be composed of semiconductor material and may include one or more dies 2002 having IC structures formed on a surface of the wafer 2000. Each of the dies 2002 may be a repeating unit of a semiconductor product that includes any suitable IC (e.g., ICs including one or more stacked vias with bottom portions formed using subtractive patterning as described herein). After the fabrication of the semiconductor product is complete (e.g., after manufacture of one or more layers of an IC structure, e.g., a metallization stack, with stacked vias with bottom portions formed using subtractive patterning as described herein), the wafer 2000 may undergo a singulation process in which each of the dies 2002 is separated from one another to provide discrete "chips" of the semiconductor product. In particular, devices that include one or more stacked vias with bottom portions formed using subtractive patterning as disclosed herein may take the form of the wafer 2000 (e.g., not singulated) or the form of the die 2002 (e.g., singulated). The die 2002 may include supporting circuitry to route electrical signals to various memory cells, transistors, capacitors, as well as any other IC components. In some embodiments, the wafer 2000 or the die 2002 may implement or include a memory device (e.g., a static RAM (SRAM) device), a logic device (e.g., an AND, OR, NAND, or NOR gate), or any other suitable circuit element. Multiple ones of these devices may be combined on a single die 2002. For example, a memory array formed by multiple memory devices may be formed on a same die 2002 as a processing device (e.g., the processing device 2402 of FIG. 8) or other logic that is configured to store information in the memory devices or execute instructions stored in the memory array.

FIG. 6 is a side, cross-sectional view of an example IC package 2200 that may include one or more stacked vias with bottom portions formed using subtractive patterning in accordance with any of the embodiments disclosed herein. In some embodiments, the IC package 2200 may be a system-in-package (SiP).

The package substrate 2252 may be formed of a dielectric material (e.g., a ceramic, a buildup film, an epoxy film having filler particles therein, etc.), and may have conductive pathways extending through the dielectric material between the face 2272 and the face 2274, or between different locations on the face 2272, and/or between different locations on the face 2274.

The package substrate 2252 may include conductive contacts 2263 that are coupled to conductive pathways 2262 through the package substrate 2252, allowing circuitry within the dies 2256 and/or the interposer 2257 to electrically couple to various ones of the conductive contacts 2264 (or to other devices included in the package substrate 2252, not shown).

The IC package 2200 may include an interposer 2257 coupled to the package substrate 2252 via conductive contacts 2261 of the interposer 2257, first-level interconnects 2265, and the conductive contacts 2263 of the package substrate 2252. The first-level interconnects 2265 illustrated in FIG. 6 are solder bumps, but any suitable first-level interconnects 2265 may be used. In some embodiments, no interposer 2257 may be included in the IC package 2200; instead, the dies 2256 may be coupled directly to the conductive contacts 2263 at the face 2272 by first-level interconnects 2265.

The IC package 2200 may include one or more dies 2256 coupled to the interposer 2257 via conductive contacts 2254 of the dies 2256, first-level interconnects 2258, and conductive contacts 2260 of the interposer 2257. The conductive contacts 2260 may be coupled to conductive pathways (not shown) through the interposer 2257, allowing circuitry within the dies 2256 to electrically couple to various ones of the conductive contacts 2261 (or to other devices included in the interposer 2257, not shown). The first-level interconnects 2258 illustrated in FIG. 6 are solder bumps, but any suitable first-level interconnects 2258 may be used. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

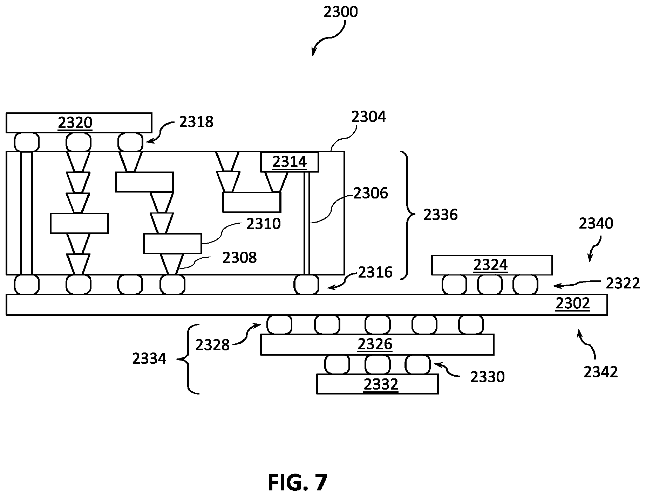

In some embodiments, an underfill material 2266 may be disposed between the package substrate 2252 and the interposer 2257 around the first-level interconnects 2265, and a mold compound 2268 may be disposed around the dies 2256 and the interposer 2257 and in contact with the package substrate 2252. In some embodiments, the underfill material 2266 may be the same as the mold compound 2268. Example materials that may be used for the underfill material 2266 and the mold compound 2268 are epoxy mold materials, as suitable. Second-level interconnects 2270 may be coupled to the conductive contacts 2264. The second-level interconnects 2270 illustrated in FIG. 6 are solder balls (e.g., for a ball grid array arrangement), but any suitable second-level interconnects 2270 may be used (e.g., pins in a pin grid array arrangement or lands in a land grid array arrangement). The second-level interconnects 2270 may be used to couple the IC package 2200 to another component, such as a circuit board (e.g., a motherboard), an interposer, or another IC package, as known in the art and as discussed below with reference to FIG. 7.

The dies 2256 may take the form of any of the embodiments of the die 2002 discussed herein (e.g., may include any of the embodiments of the IC structures with one or more stacked vias with bottom portions formed using subtractive patterning as described herein). In embodiments in which the IC package 2200 includes multiple dies 2256, the IC package 2200 may be referred to as a multi-chip package (MCP). The dies 2256 may include circuitry to perform any desired functionality. For example, one or more of the dies 2256 may be logic dies (e.g., silicon-based dies), and one or more of the dies 2256 may be memory dies (e.g., high bandwidth memory). In some embodiments, any of the dies 2256 may include one or more IC structures with one or more stacked vias with bottom portions formed using subtractive patterning as discussed above; in some embodiments, at least some of the dies 2256 may not include any stacked vias with bottom portions formed using subtractive patterning.

The IC package 2200 illustrated in FIG. 6 may be a flip chip package, although other package architectures may be used. For example, the IC package 2200 may be a ball grid array (BGA) package, such as an embedded wafer-level ball grid array (eWLB) package. In another example, the IC package 2200 may be a wafer-level chip scale package (WLCSP) or a panel fan-out (FO) package. Although two dies 2256 are illustrated in the IC package 2200 of FIG. 6, an IC package 2200 may include any desired number of the dies 2256. An IC package 2200 may include additional passive components, such as surface-mount resistors, capacitors, and inductors disposed on the first face 2272 or the second face 2274 of the package substrate 2252, or on either face of the interposer 2257. More generally, an IC package 2200 may include any other active or passive components known in the art.

FIG. 7 is a cross-sectional side view of an IC device assembly 2300 that may include components having one or more stacked vias with bottom portions formed using subtractive patterning in accordance with any of the embodiments disclosed herein. The IC device assembly 2300 includes a number of components disposed on a circuit board 2302 (which may be, e.g., a motherboard). The IC device assembly 2300 includes components disposed on a first face 2340 of the circuit board 2302 and an opposing second face 2342 of the circuit board 2302; generally, components may be disposed on one or both faces 2340 and 2342. In particular, any suitable ones of the components of the IC device assembly 2300 may include any of one or more stacked vias with bottom portions formed using subtractive patterning in accordance with any of the embodiments disclosed herein; e.g., any of the IC packages discussed below with reference to the IC device assembly 2300 may take the form of any of the embodiments of the IC package 2200 discussed above with reference to FIG. 6 (e.g., may include one or more stacked vias with bottom portions formed using subtractive patterning provided on a die 2256).

In some embodiments, the circuit board 2302 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 2302. In other embodiments, the circuit board 2302 may be a non-PCB substrate.

The IC device assembly 2300 illustrated in FIG. 7 includes a package-on-interposer structure 2336 coupled to the first face 2340 of the circuit board 2302 by coupling components 2316. The coupling components 2316 may electrically and mechanically couple the package-on-interposer structure 2336 to the circuit board 2302, and may include solder balls (e.g., as shown in FIG. 7), male and female portions of a socket, an adhesive, an underfill material, and/or any other suitable electrical and/or mechanical coupling structure.

The package-on-interposer structure 2336 may include an IC package 2320 coupled to an interposer 2304 by coupling components 2318. The coupling components 2318 may take any suitable form for the application, such as the forms discussed above with reference to the coupling components 2316. The IC package 2320 may be or include, for example, a die (the die 2002 of FIG. 5B), an IC device, or any other suitable component. In particular, the IC package 2320 may include one or more stacked vias with bottom portions formed using subtractive patterning as described herein. Although a single IC package 2320 is shown in FIG. 7, multiple IC packages may be coupled to the interposer 2304; indeed, additional interposers may be coupled to the interposer 2304. The interposer 2304 may provide an intervening substrate used to bridge the circuit board 2302 and the IC package 2320. Generally, the interposer 2304 may spread a connection to a wider pitch or reroute a connection to a different connection. For example, the interposer 2304 may couple the IC package 2320 (e.g., a die) to a BGA of the coupling components 2316 for coupling to the circuit board 2302. In the embodiment illustrated in FIG. 7, the IC package 2320 and the circuit board 2302 are attached to opposing sides of the interposer 2304; in other embodiments, the IC package 2320 and the circuit board 2302 may be attached to a same side of the interposer 2304. In some embodiments, three or more components may be interconnected by way of the interposer 2304.

The interposer 2304 may be formed of an epoxy resin, a fiberglass-reinforced epoxy resin, a ceramic material, or a polymer material such as polyimide. In some implementations, the interposer 2304 may be formed of alternate rigid or flexible materials that may include the same materials described above for use in a semiconductor substrate, such as silicon, germanium, and other group III-V and group IV materials. The interposer 2304 may include any number of metal lines 2310, vias 2308, and through-silicon vias (TSVs) 2306. The interposer 2304 may further include embedded devices 2314, including both passive and active devices. Such devices may include, but are not limited to, capacitors, decoupling capacitors, resistors, inductors, fuses, diodes, transformers, sensors, electrostatic discharge (ESD) protection devices, and memory devices. More complex devices such as RF devices, power amplifiers, power management devices, antennas, arrays, sensors, and microelectromechanical systems (MEMS) devices may also be formed on the interposer 2304. The package-on-interposer structure 2336 may take the form of any of the package-on-interposer structures known in the art.

The IC device assembly 2300 may include an IC package 2324 coupled to the first face 2340 of the circuit board 2302 by coupling components 2322. The coupling components 2322 may take the form of any of the embodiments discussed above with reference to the coupling components 2316, and the IC package 2324 may take the form of any of the embodiments discussed above with reference to the IC package 2320.

The IC device assembly 2300 illustrated in FIG. 7 includes a package-on-package structure 2334 coupled to the second face 2342 of the circuit board 2302 by coupling components 2328. The package-on-package structure 2334 may include an IC package 2326 and an IC package 2332 coupled together by coupling components 2330 such that the IC package 2326 is disposed between the circuit board 2302 and the IC package 2332. The coupling components 2328 and 2330 may take the form of any of the embodiments of the coupling components 2316 discussed above, and the IC packages 2326 and 2332 may take the form of any of the embodiments of the IC package 2320 discussed above. The package-on-package structure 2334 may be configured in accordance with any of the package-on-package structures known in the art.

FIG. 8 is a block diagram of an example computing device 2400 that may include one or more components with one or more stacked vias with bottom portions formed using subtractive patterning in accordance with any of the embodiments disclosed herein. For example, any suitable ones of the components of the computing device 2400 may include a die (e.g., the die 2002, shown in FIG. 5B) implementing stacked vias with bottom portions formed using subtractive patterning in accordance with any of the embodiments disclosed herein. Any of the components of the computing device 2400 may include an IC package 2200 (e.g., as shown in FIG. 6). Any of the components of the computing device 2400 may include an IC device assembly 2300 (e.g., as shown in FIG. 7).

A number of components are illustrated in FIG. 8 as included in the computing device 2400, but any one or more of these components may be omitted or duplicated, as suitable for the application. In some embodiments, some or all of the components included in the computing device 2400 may be attached to one or more motherboards. In some embodiments, some or all of these components are fabricated onto a single system on a chip (SoC) die.

Additionally, in various embodiments, the computing device 2400 may not include one or more of the components illustrated in FIG. 8, but the computing device 2400 may include interface circuitry for coupling to the one or more components. For example, the computing device 2400 may not include a display device 2406, but may include display device interface circuitry (e.g., a connector and driver circuitry) to which a display device 2406 may be coupled. In another set of examples, the computing device 2400 may not include an audio input device 2418 or an audio output device 2408, but may include audio input or output device interface circuitry (e.g., connectors and supporting circuitry) to which an audio input device 2418 or audio output device 2408 may be coupled.

The computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 2402 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The computing device 2400 may include a memory 2404, which may itself include one or more memory devices such as volatile memory (e.g., DRAM), nonvolatile memory (e.g., read-only memory (ROM)), flash memory, solid state memory, and/or a hard drive. In some embodiments, the memory 2404 may include memory that shares a die with the processing device 2402.

In some embodiments, the computing device 2400 may include a communication chip 2412 (e.g., one or more communication chips). For example, the communication chip 2412 may be configured for managing wireless communications for the transfer of data to and from the computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 2412 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 2412 may operate in accordance with other wireless protocols in other embodiments. The computing device 2400 may include an antenna 2422 to facilitate wireless communications and/or to receive other wireless communications (such as AM or FM radio transmissions).

In some embodiments, the communication chip 2412 may manage wired communications, such as electrical, optical, or any other suitable communication protocols (e.g., the Ethernet). As noted above, the communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

The computing device 2400 may include battery/power circuitry 2414. The battery/power circuitry 2414 may include one or more energy storage devices (e.g., batteries or capacitors) and/or circuitry for coupling components of the computing device 2400 to an energy source separate from the computing device 2400 (e.g., AC line power).

The computing device 2400 may include a display device 2406 (or corresponding interface circuitry, as discussed above). The display device 2406 may include any visual indicators, such as a heads-up display, a computer monitor, a projector, a touchscreen display, a liquid crystal display (LCD), a light-emitting diode display, or a flat panel display, for example.

The computing device 2400 may include an audio output device 2408 (or corresponding interface circuitry, as discussed above). The audio output device 2408 may include any device that generates an audible indicator, such as speakers, headsets, or earbuds, for example.

The computing device 2400 may include an audio input device 2418 (or corresponding interface circuitry, as discussed above). The audio input device 2418 may include any device that generates a signal representative of a sound, such as microphones, microphone arrays, or digital instruments (e.g., instruments having a musical instrument digital interface (MIDI) output).

The computing device 2400 may include a GPS device 2416 (or corresponding interface circuitry, as discussed above). The GPS device 2416 may be in communication with a satellite-based system and may receive a location of the computing device 2400, as known in the art.

The computing device 2400 may include an other output device 2410 (or corresponding interface circuitry, as discussed above). Examples of the other output device 2410 may include an audio codec, a video codec, a printer, a wired or wireless transmitter for providing information to other devices, or an additional storage device.

The computing device 2400 may include an other input device 2420 (or corresponding interface circuitry, as discussed above). Examples of the other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 2400 may be any other electronic device that processes data.

## Claims

1. An integrated circuit (IC) structure, comprising:
a support structure (202);
a first metallization layer (204) and a second metallization layer (216) over the support structure, where the first metallization layer (204) includes a bottom electrically conductive line (211), the second metallization layer (216) includes a top electrically conductive line (227), and the first metallization layer (204) is between the support structure (202) and the second metallization layer (216); and
a via having a bottom via portion (209) coupled to the bottom electrically conductive line (211) and a top via portion coupled to the top electrically conductive line (227),
wherein:
the bottom via portion (209) is self-aligned to the bottom electrically conductive line (211), and
the top via portion is self-aligned to the top electrically conductive line (227),
wherein
each of the bottom via portion (209) and a top via portion has a first face (F1t, F1b), a second face (F2t, F2b), a third face (F3t, F3b), and a fourth face (F4t, F4b), where the second face (F2t, F2b) is opposite the first face (F1t, F1b), and where the fourth face (F4t, F4b) is opposite the third face (F3t, F3b),
the first face (F1b) of the bottom via portion (209) is in a single plane with a first sidewall of the bottom electrically conductive line (211),
the second face (F2b) of the bottom via portion (209) is in a single plane with a second sidewall of the bottom electrically conductive line (211),
the third face (F3t) of the top via portion is in a single plane with a first sidewall of the top electrically conductive line (227), and
the fourth face (F4t) of the top via portion being in a single plane with a second sidewall of the top electrically conductive line (227), wherein
a distance between the first (F1t) and second faces (F12) of the bottom via portion (209) is smaller than a distance between the first (F1t) and second faces (F2t) of the top via portion.

2. The IC structure according to claim 1, wherein a distance between the third (F3t) and fourth faces (F4t) of the top via portion is smaller than a distance between the third (F3b) and fourth faces (F4b) of the bottom via portion (209).

3. The IC structure according to any one of the preceding claims, wherein each of the first (F1b) and second faces (F2b) of the bottom via portion (209) is substantially flat.

4. The IC structure according to any one of the preceding claims, wherein each of the third (F3t) and fourth faces (F4t) of the top via portion is substantially flat.

5. An electronic device, comprising:
a circuit board; and
an integrated circuit (IC) die, coupled to the circuit board, the IC die including an IC structure according to any one of the preceding claims.

6. The electronic device according to claim 5, further including one or more communication chips and an antenna.

7. The electronic device according to claims 5 or 6, wherein the electronic device is a wearable electronic device or a handheld electronic device.

8. The electronic device according to claims 5 or 6, wherein the electronic device is a motherboard.

9. A method of fabricating an integrated circuit (IC) structure, the method comprising:
providing, over a support structure, a stack of a first electrically conductive material and a first mask material;
forming a bottom line pattern in the first mask material to define a top-down shape and a location of a bottom electrically conductive line;
forming the bottom electrically conductive line by removing the first electrically conductive material not covered by the bottom line pattern;
forming a bottom via portion pattern in the bottom line pattern to define a top-down shape and a location of a bottom via portion;
forming the bottom via portion by recessing the first electrically conductive material not covered by the bottom via portion pattern;
removing the first mask material over the bottom via portion;
providing a stack of a first dielectric material and a second mask material;
forming a top line pattern in the second mask material to define a top-down shape and a location of a top electrically conductive line;
forming an opening for the top electrically conductive line by removing the first dielectric material not covered by the top line pattern;
providing a stack of a second dielectric material and a third mask material;
forming a top via portion pattern in the third mask material to define a top-down shape and a location of a top via portion;
forming an intermediate top via portion opening by removing the second dielectric material not covered by the top via portion pattern and not covered by the top line pattern;
forming a top via portion opening by removing the first dielectric material exposed by the intermediate top via portion opening; and
depositing a second electrically conductive material in the top via portion opening and the opening for the top electrically conductive line, wherein the second electrically conductive material in the top via portion opening forms the top via portion and the second electrically conductive material in the opening for the top electrically conductive line forms the top electrically conductive line.

10. The method according to claim 9, further including:
removing excess of the second electrically conductive material so that an upper surface of the second electrically conductive material is substantially flush with an upper surface of the first dielectric material.

## Patentansprüche

1. IC-Struktur (IC: Integrated Circuit), die Folgendes umfasst:
eine Stützstruktur (202);
eine erste Metallisierungsschicht (204) und eine zweite Metallisierungsschicht (216) über der Stützstruktur, wobei die erste Metallisierungsschicht (204) eine untere elektrisch leitfähige Leitung (211) aufweist, die zweite Metallisierungsschicht (216) eine obere elektrisch leitfähige Leitung (227) aufweist und die erste Metallisierungsschicht (204) zwischen der Stützstruktur (202) und der zweiten Metallisierungsschicht (216) liegt;
und
eine Durchkontaktierung mit einem unteren Durchkontaktierungsabschnitt (209), der mit der unteren elektrisch leitfähigen Leitung (211) gekoppelt ist, und einem oberen Durchkontaktierungsabschnitt, der mit der oberen elektrisch leitfähigen Leitung (227) gekoppelt ist,
wobei:
der untere Durchkontaktierungsabschnitt (209) zu der unteren elektrisch leitfähigen Leitung (211) selbstjustiert ist und
der obere Durchkontaktierungsabschnitt zu der oberen elektrisch leitfähigen Leitung (227) selbstjustiert ist,
wobei
sowohl der untere Durchkontaktierungsabschnitt (209) als auch ein oberer Durchkontaktierungsabschnitt eine erste Fläche (F1t, F1b), eine zweite Fläche (F2t, F2b), eine dritte Fläche (F3t, F3b) und eine vierte Fläche (F4t, F4b) aufweisen, wobei die zweite Fläche (F2t, F2b) der ersten Fläche (F1t, F1b) gegenüberliegt und wobei die vierte Fläche (F4t, F4b) der dritten Fläche (F3t, F3b) gegenüberliegt,
die erste Fläche (F1b) des unteren Durchkontaktierungsabschnitts (209) in einer einzigen Ebene mit einer ersten Seitenwand der unteren elektrisch leitfähigen Leitung (211) liegt,
die zweite Fläche (F2b) des unteren Durchkontaktierungsabschnitts (209) in einer einzigen Ebene mit einer zweiten Seitenwand der unteren elektrisch leitfähigen Leitung (211) liegt,
die dritte Fläche (F3t) des oberen Durchkontaktierungsabschnitts in einer einzigen Ebene mit einer ersten Seitenwand der oberen elektrisch leitfähigen Leitung (227) liegt und
die vierte Fläche (F4t) des oberen Durchkontaktierungsabschnitts in einer einzigen Ebene mit einer zweiten Seitenwand der oberen elektrisch leitfähigen Leitung (227) liegt, wobei
ein Abstand zwischen der ersten (F1t) und der zweiten Fläche (F12) des unteren Durchkontaktierungsabschnitts (209) kleiner als ein Abstand zwischen der ersten (F1t) und der zweiten Fläche (F2t) des oberen Durchkontaktierungsabschnitts ist.

2. IC-Struktur nach Anspruch 1, wobei ein Abstand zwischen der dritten (F3t) und der vierten Fläche (F4t) des oberen Durchkontaktierungsabschnitts kleiner als ein Abstand zwischen der dritten (F3b) und der vierten Fläche (F4b) des unteren Durchkontaktierungsabschnitts (209) ist.

3. IC-Struktur nach einem der vorhergehenden Ansprüche, wobei sowohl die erste (F1b) als auch die zweite Fläche (F2b) des unteren Durchkontaktierungsabschnitts (209) im Wesentlichen flach sind.

4. IC-Struktur nach einem der vorhergehenden Ansprüche, wobei sowohl die dritte (F3t) als auch die vierte Fläche (F4t) des oberen Durchkontaktierungsabschnitts im Wesentlichen flach sind.

5. Elektronische Vorrichtung, die Folgendes umfasst:
eine Leiterplatte; und
einen IC-Die (IC: Integrated Circuit), der mit der Leiterplatte gekoppelt ist, wobei der IC-Die eine IC-Struktur nach einem der vorhergehenden Ansprüche aufweist.

6. Elektronische Vorrichtung nach Anspruch 5, die ferner einen oder mehrere Kommunikationschips und eine Antenne aufweist.

7. Elektronische Vorrichtung nach Anspruch 5 oder 6, wobei die elektronische Vorrichtung eine am Körper tragbare elektronische Vorrichtung oder eine handgehaltene elektronische Vorrichtung ist.

8. Elektronische Vorrichtung nach Anspruch 5 oder 6, wobei die elektronische Vorrichtung eine Hauptplatine ist.

9. Verfahren zum Fertigen einer IC-Struktur (IC:
Integrated Circuit), wobei das Verfahren Folgendes umfasst:
Bereitstellen, über einer Stützstruktur, eines Stapels aus einem ersten elektrisch leitfähigen Material und einem ersten Maskenmaterial;
Bilden eines unteren Leitungsmusters in dem ersten Maskenmaterial, um eine Draufsichtform und eine Position einer unteren elektrisch leitfähigen Leitung zu definieren;
Bilden der unteren elektrisch leitfähigen Leitung durch Entfernen des ersten elektrisch leitfähigen Materials, das nicht von dem unteren Leitungsmuster bedeckt wird;
Bilden eines unteren Durchkontaktierungsabschnittsmusters in dem unteren Leitungsmuster, um eine Draufsichtform und eine Position eines unteren Durchkontaktierungsabschnitts zu definieren;
Bilden des unteren Durchkontaktierungsabschnitts durch Vertiefen des ersten elektrisch leitfähigen Materials, das nicht von dem unteren Durchkontaktierungsabschnittsmuster bedeckt wird;
Entfernen des ersten Maskenmaterials über dem unteren Durchkontaktierungsabschnitt;
Bereitstellen eines Stapels aus einem ersten dielektrischen Material und einem zweiten Maskenmaterial;
Bilden eines oberen Leitungsmusters in dem zweiten Maskenmaterial, um eine Draufsichtform und eine Position einer oberen elektrisch leitfähigen Leitung zu definieren;
Bilden einer Öffnung für die obere elektrisch leitfähige Leitung durch Entfernen des ersten dielektrischen Materials, das nicht von dem oberen Leitungsmuster bedeckt wird;
Bereitstellen eines Stapels aus einem zweiten dielektrischen Material und einem dritten Maskenmaterial;
Bilden eines oberen Durchkontaktierungsabschnittsmusters in dem dritten Maskenmaterial, um eine Draufsichtform und eine Position eines oberen Durchkontaktierungsabschnitts zu definieren;
Bilden einer Zwischenöffnung des oberen Durchkontaktierungsabschnitts durch Entfernen des zweiten dielektrischen Materials, das nicht von dem oberen Durchkontaktierungsabschnittsmuster bedeckt wird und nicht von dem oberen Leitungsmuster bedeckt wird;
Bilden einer Öffnung des oberen Durchkontaktierungsabschnitts durch Entfernen des ersten dielektrischen Materials, das durch die Zwischenöffnung des oberen Durchkontaktierungsabschnitts freigelegt wird; und
Abscheiden eines zweiten elektrisch leitfähigen Materials in der Öffnung des oberen Durchkontaktierungsabschnitts und der Öffnung für die obere elektrisch leitfähige Leitung, wobei das zweite elektrisch leitfähige Material in der Öffnung des oberen Durchkontaktierungsabschnitts den oberen Durchkontaktierungsabschnitt bildet und das zweite elektrisch leitfähige Material in der Öffnung für die obere elektrisch leitfähige Leitung die obere elektrisch leitfähige Leitung bildet.

10. Verfahren nach Anspruch 9, das ferner Folgendes beinhaltet:
Entfernen von überschüssigem zweitem elektrisch leitfähigem Material, so dass eine oben liegende Oberfläche des zweiten elektrisch leitfähigen Materials im Wesentlichen bündig mit einer oben liegenden Oberfläche des ersten dielektrischen Materials ist.

## Revendications

1. Structure de circuit intégré (CI), comprenant :
une structure de support (202) ;
une première couche de métallisation (204) et une seconde couche de métallisation (216) sur la structure de support, la première couche de métallisation (204) comportant une ligne électroconductrice inférieure (211), la seconde couche de métallisation (216) comportant une ligne électroconductrice supérieure (227), et la première couche de métallisation (204) étant entre la structure de support (202) et la seconde couche de métallisation (216) ; et
un trou d'interconnexion présentant une partie de trou d'interconnexion inférieure (209) couplée à la ligne électroconductrice inférieure (211) et une partie de trou d'interconnexion supérieure couplée à la ligne électroconductrice supérieure (227),
dans lequel :
la partie de trou d'interconnexion inférieure (209) est auto-alignée sur la ligne électroconductrice inférieure (211), et
la partie de trou d'interconnexion supérieure est auto-alignée sur la ligne électroconductrice supérieure (227), dans lequel
chacune de la partie de trou d'interconnexion inférieure (209) et de la partie de trou d'interconnexion supérieure a une première face (F1t, F1b), une deuxième face (F2t, F2b), une troisième face (F3t, F3b), et une quatrième face (F4t, F4b), la deuxième face (F2t, F2b) étant opposée à la première face (F1t, F1b), et la quatrième face (F4t, F4b) étant opposée à la troisième face (F3t, F3b),
la première face (F1b) de la partie de trou d'interconnexion inférieure (209) est dans un plan unique avec une première paroi latérale de la ligne électroconductrice inférieure (211),
la deuxième face (F2b) de la partie de trou d'interconnexion inférieure (209) est dans un plan unique avec une seconde paroi latérale de la ligne électroconductrice inférieure (211),
la troisième face (F3t) de la partie de trou d'interconnexion supérieure est dans un plan unique avec une première paroi latérale de la ligne électroconductrice supérieure (227), et
la quatrième face (F4t) de la partie de trou d'interconnexion supérieure étant dans un plan unique avec une seconde paroi latérale de la ligne électroconductrice supérieure (227), dans laquelle
une distance entre les première (F1t) et deuxième (F12) faces de la partie de trou d'interconnexion inférieure (209) est plus petite qu'une distance entre les première (F1t) et deuxième (F2t) faces de la partie de trou d'interconnexion supérieure.

2. Structure de CI selon la revendication 1, dans laquelle une distance entre les troisième (F3t) et quatrième (F4t) faces de la partie de trou d'interconnexion supérieure est plus petite qu'une distance entre les troisième (F3b) et quatrième (F4b) faces de la partie de trou d'interconnexion inférieure (209).

3. Structure de CI selon l'une quelconque des revendications précédentes, dans laquelle chacune des première (F1b) et deuxième (F2b) faces de la partie de trou d'interconnexion inférieure (209) est sensiblement plate.

4. Structure de CI selon l'une quelconque des revendications précédentes, dans laquelle chacune des troisième (F3t) et quatrième (F4t) faces de la partie de trou d'interconnexion supérieure est sensiblement plate.

5. Dispositif électronique, comprenant :
une carte de circuit imprimé ; et
une puce de circuit intégré (CI), couplée à la carte de circuit imprimé, la puce de CI comportant une structure de CI selon l'une quelconque des revendications précédentes.

6. Dispositif électronique selon la revendication 5, comportant en outre une ou plusieurs puces de communication et une antenne.

7. Dispositif électronique selon la revendication 5 ou 6, dans lequel le dispositif électronique est un dispositif électronique à porter sur soi ou un dispositif électronique portatif.

8. Dispositif électronique selon la revendication 5 ou 6, dans lequel le dispositif électronique est une carte mère.

9. Procédé de fabrication d'une structure de circuit intégré (CI), le procédé comprenant :
la fourniture, sur une structure de support, d'un empilement d'un premier matériau électroconducteur et d'un premier matériau de masque ;
la formation d'un motif de ligne inférieur dans le premier matériau de masque pour définir une forme de haut en bas et un emplacement d'une ligne électroconductrice inférieure ;
la formation de la ligne électroconductrice inférieure en retirant le premier matériau électroconducteur non recouvert par le motif de ligne inférieur ;
la formation d'un motif de partie de trou d'interconnexion inférieure dans le motif de ligne inférieur pour définir une forme de haut en bas et un emplacement d'une partie de trou d'interconnexion inférieure ;
la formation de la partie de trou d'interconnexion inférieure en évidant le premier matériau électroconducteur non recouvert par le motif de partie de trou d'interconnexion inférieure ;
le retrait du premier matériau de masque sur la partie de trou d'interconnexion inférieure ;
la fourniture d'un empilement d'un premier matériau diélectrique et d'un deuxième matériau de masque ;
la formation d'un motif de ligne inférieur dans le deuxième matériau de masque pour définir une forme de haut en bas et un emplacement d'une ligne électroconductrice supérieure ;
la formation d'une ouverture pour la ligne électroconductrice supérieure en retirant le premier matériau diélectrique non recouvert par le motif de ligne supérieur ;
la fourniture d'un empilement d'un second matériau diélectrique et d'un troisième matériau de masque ;
la formation d'un motif de partie de trou d'interconnexion supérieure dans le troisième matériau de masque pour définir une forme de haut en bas et un emplacement d'une partie de trou d'interconnexion supérieure ;
la formation d'une ouverture de partie de trou d'interconnexion supérieure intermédiaire par retrait du second matériau diélectrique non recouvert par le motif de partie de trou d'interconnexion supérieure et non recouvert par le motif de ligne supérieur ;
la formation d'une ouverture de partie de trou d'interconnexion supérieure par retrait du premier matériau diélectrique exposé par l'ouverture de partie de trou d'interconnexion supérieure intermédiaire ; et
le dépôt d'un second matériau électroconducteur dans l'ouverture de partie de trou d'interconnexion supérieure et l'ouverture pour la ligne électroconductrice supérieure, dans lequel le second matériau électroconducteur dans l'ouverture de partie de trou d'interconnexion supérieure forme la partie de trou d'interconnexion supérieure et le second matériau électroconducteur dans l'ouverture pour la ligne électroconductrice supérieure forme la ligne électroconductrice supérieure.

10. Procédé selon la revendication 9, comportant en outre :
le retrait de l'excès du second matériau électroconducteur de sorte qu'une surface supérieure du second matériau électroconducteur affleure sensiblement une surface supérieure du premier matériau diélectrique.
